# EUROPEAN PATENT APPLICATION

(11) **EP 4 593 292 A1**
(43) Date of publication of application: **30.07.2025**
(21) Application number: 22963217.9
(22) Date of filing: 29.10.2022
(51) Int. Cl.: H03M 1/12

(54) **ANALOG-TO-DIGITAL CONVERTER AND SIGNAL PROCESSING DEVICE**

(71) Applicant: Huawei Technologies Co., Ltd., Shenzhen, Guangdong 518129 (CN)
(72) Inventor: GUO, Shaonan, Shenzhen, Guangdong 518129 (CN); LUO, Yang, Shenzhen, Guangdong 518129 (CN); LIANG, Xiangru, Shenzhen, Guangdong 518129 (CN); ZHOU, Chongbin, Shenzhen, Guangdong 518129 (CN); HU, Kebin, Shenzhen, Guangdong 518129 (CN); XIAO, Yuxiang, Shenzhen, Guangdong 518129 (CN)
(74) Representative: Körber, Martin Hans
(86) International application number: PCT/CN2022/128458
(87) International publication number: WO 2024/087236

(57) **Abstract**

This application discloses an analog-to-digital converter and a signal processing apparatus. In this solution, a low-power module in the analog-to-digital converter (namely, an ADC) may control, based on a received indication signal, whether a first-stage sub-ADC in the ADC is to normally perform analog-to-digital conversion, so that a processing bit width of the ADC can be adjusted. When the processing bit width of the ADC is reduced, power consumption of the ADC is also reduced accordingly. Therefore, this application provides a solution for reducing the power consumption of the ADC by adjusting the processing bit width of the ADC.

## Description

### TECHNICAL FIELD

This application relates to the field of circuit designs, and in particular, to an analog-to-digital converter (Analog-to-Digital Converter, ADC) and a signal processing apparatus.

### BACKGROUND

An electronic device involves not only a digital signal, but also an analog signal. Therefore, an ADC having an analog-to-digital conversion function is an important part of the electronic device. In addition, the ADC is used as an active component, and power consumption of the ADC is an important part of total power consumption of the electronic device.

With evolution of communication technologies, signal bandwidth is increasingly large, and in the field of communication, an ADC rate requirement is increasingly high. A processing bit width of the ADC, as an important indicator closely coupled with an ADC rate, has a significant impact on the power consumption of the ADC.

To ensure standardization and consistency, a processing bit width of the electronic device is fixed, for example, is common 12 bits (bits) or 16 bits. For example, a data bit width of a base station in a 5th generation (5th generation, 5G) communication system is generally about 16 bits.

However, in actual running of a processing service of the electronic device, bit width utilization is not high. Consequently, service data that needs to be processed by the ADC does not match a processing resource provided by the ADC, resulting in costs of additional power consumption of the ADC.

### SUMMARY

This application provides an ADC and a signal processing apparatus, to adjust a processing bit width of the ADC, so that power consumption of the ADC is reduced.

According to a first aspect, an embodiment of this application provides an ADC. The ADC includes: a first-stage sub-ADC, a second-stage sub-ADC, a first interstage amplifier, a digital control module, a low-power control module, and a first multiplexer, where functions of each module in the ADC are as follows:
The low-power control module is configured to: send a first control signal to the first-stage sub-ADC and send a first selection signal to the first multiplexer based on a received first indication signal; or send a second control signal to the first-stage sub-ADC and send a second selection signal to the first multiplexer based on a received second indication signal, where the first control signal indicates the first-stage sub-ADC to perform analog-to-digital conversion on a first input analog signal; the first selection signal indicates the first multiplexer to select a signal that is input through a first input end; the second control signal indicates the first-stage sub-ADC to skip performing analog-to-digital conversion on a first input analog signal; and the second selection signal indicates the first multiplexer to select a signal that is input through a second input end;
the first-stage sub-ADC is configured to: when receiving the first control signal, perform analog-to-digital conversion on the first input analog signal based on the first control signal and a first reference analog signal, to generate a first M-bit digital signal, and send the first M-bit digital signal to the digital control module; correct the first input analog signal based on the first M-bit digital signal, to generate the first corrected input analog signal; and send the first corrected input analog signal to the first input end of the first multiplexer;
the first-stage sub-ADC is further configured to: when receiving the second control signal, skip performing analog-to-digital conversion on the first input analog signal based on the second control signal;
the first multiplexer is configured to: receive the first corrected input analog signal from the first-stage sub-ADC through the first input end, and receive the first input analog signal through the second input end; when receiving the first selection signal, select, based on the first selection signal, the signal that is input through the first input end as a second input analog signal; or when receiving the second selection signal, select, based on the second selection signal, the signal that is input through the second input end as a second input analog signal; and send a signal obtained by amplifying the second input analog signal to the first interstage amplifier;
the first interstage amplifier is configured to: amplify the received second input analog signal, and send a signal obtained by amplifying the second input analog signal to the second-stage sub-ADC;
the second-stage sub-ADC is configured to: perform analog-to-digital conversion on the second input analog signal based on a second reference analog signal, to generate a first N-bit digital signal, and send the first N-bit digital signal to the digital control module; and
the digital control module is configured to: perform correction control on the received first M-bit digital signal and the received first N-bit digital signal, to generate a first (M+N)-bit output digital signal; or perform correction control on the received first N-bit digital signal, to generate a first N-bit output digital signal, where M is a positive integer, and N is a positive integer.

According to this solution, the low-power control module in the ADC may control, based on a received indication signal (the first indication signal or the second indication signal), whether the first-stage sub-ADC in the ADC is to normally perform analog-to-digital conversion. When the first-stage sub-ADC operates, a processing bit width of the ADC is M+N. When the first-stage sub-ADC does not operate, a processing bit width of the ADC is N. Therefore, a preceding-stage module may send the indication signal to the ADC based on an amplitude of service data or another case, to adjust the processing bit width of the ADC. In this way, power consumption of the ADC is reduced after the processing bit width of the ADC is reduced.

In a possible design, the low-power control module is specifically configured to: in a first mode, send the first control signal to the first-stage sub-ADC and send the first selection signal to the first multiplexer based on the received first indication signal; or, send the second control signal to the first-stage sub-ADC and send the second selection signal to the first multiplexer based on the received second indication signal;
the low-power control module is further configured to: in a second mode, send a third control signal to the first-stage sub-ADC, where the third control signal indicates the first-stage sub-ADC to determine, based on a magnitude of the first input analog signal, whether to perform analog-to-digital conversion on the first input analog signal;
the first-stage sub-ADC is further configured to: compare the first input analog signal with a specified signal based on the third control signal; and when the first input analog signal is greater than the specified signal, perform analog-to-digital conversion on the first input analog signal based on the first reference analog signal, to generate a second M-bit digital signal, and send the second M-bit digital signal to the digital control module; correct the first input analog signal based on the second M-bit digital signal, to generate a second corrected input analog signal; send the second corrected input analog signal to the first input end of the first multiplexer; and send a third selection signal to the first multiplexer, where the third selection signal indicates the first multiplexer to select the signal that is input through the first input end; or when the first input analog signal is less than the specified signal, skip performing analog-to-digital conversion on the first input analog signal, and send a fourth selection signal to the first multiplexer, where the fourth selection signal indicates the first multiplexer to select the signal that is input through the second input end;
the first multiplexer is further configured to: receive the second corrected input analog signal from the first-stage sub-ADC through the first input end, and receive the first input analog signal through the second input end; when receiving the third selection signal, select, based on the third selection signal, the signal that is input through the first input end as a third input analog signal; or when receiving the fourth selection signal, select, based on the fourth selection signal, the signal that is input through the second input end as a third input analog signal; and send a signal obtained by amplifying the third input analog signal to the first interstage amplifier;
the first interstage amplifier is further configured to: amplify the received third input analog signal, and send a signal obtained by amplifying the third input analog signal to the second-stage sub-ADC;
the second-stage sub-ADC is further configured to: perform analog-to-digital conversion on the third input analog signal based on the second reference analog signal, to generate a second N-bit digital signal, and send the second N-bit digital signal to the digital control module; and
the digital control module is further configured to: perform correction control on the received second M-bit digital signal and the received second N-bit digital signal, to generate a second (M+N)-bit output digital signal; or perform correction control on the received second N-bit digital signal, to generate a second N-bit output digital signal.

According to this design, when the low-power control module in the ADC is in the second mode, the first-stage sub-ADC in the ADC may determine, based on a magnitude of an input analog signal, whether to normally perform analog-to-digital conversion. When the first-stage sub-ADC operates, a processing bit width of the ADC is M+N. When the first-stage sub-ADC does not operate, a processing bit width of the ADC is N. Therefore, when the low-power control module in the ADC is controlled to be in the second mode, the ADC may adaptively adjust the processing bit width of the ADC based on the magnitude of the analog signal that is input to the ADC. In this way, the power consumption of the ADC is reduced after the processing bit width of the ADC is reduced.

In a possible design, a value of the specified signal is equal to a value of the first reference analog signal× 1/2^{M}.

In a possible design, the low-power control module includes a selection control module and a signal generation module;
the signal generation module is configured to: generate, in the second mode, the third control signal; and
the selection control module is configured to: receive the first indication signal or the second indication signal through a first input end; and receive the third control signal of the signal generation module through a second input end; and
in the first mode, send the first control signal to the first-stage sub-ADC and send the first selection signal to the first multiplexer based on the first indication signal received through the first input end; or send the second control signal to the first-stage sub-ADC and send the second selection signal to the first multiplexer based on the second indication signal received through the first input end; or
send, in the second mode, the third control signal received through the second input end to the first-stage sub-ADC.

In a possible design, the selection control module is a second multiplexer; and a value of the first indication signal, a value of the first control signal, and a value of the first selection signal are the same; or a value of the second indication signal, a value of the second control signal, and a value of the second selection signal are the same; and
the second multiplexer is configured to: select, in the first mode, a signal that is input through the first input end; or select, in the second mode, a signal that is input through the second input end.

In a possible design, the first indication signal or the second indication signal is generated by a preceding-stage module of the ADC based on service data of a specified granularity, and the service data of the specified granularity is a single piece of sampled data, or service data received within specified time.

In a possible design, the value of the first reference analog signal is the same as a value of the second reference analog signal; or a value of the second reference analog signal is equal to the value of the first reference analog signal×1/2^{K}, where K is a positive integer less than or equal to M; and an operation parameter of the first interstage amplifier is set based on the value of the first reference analog signal and the value of the second reference analog signal.

In a possible design, a value of the second reference analog signal is equal to a value of the first reference analog signal×1/2^{M}, and the specified signal is the second reference analog signal; and the first-stage sub-ADC includes a controller, and the controller is configured to: when receiving the third control signal, turn on a switch between the second reference analog signal and the first-stage sub-ADC.

According to this design, the first-stage sub-ADC may not need to generate the specified signal, so that power consumption caused by generating the specified signal is reduced.

According to a second aspect, an embodiment of this application provides an ADC, including: a first-stage sub-ADC, a second-stage sub-ADC, a first interstage amplifier, a digital control module, a low-power control module, and a first multiplexer, where functions of each module in the ADC are as follows:
The low-power control module is configured to: based on a received first bit width indication signal, send a first control signal to the first-stage sub-ADC, send a first selection signal to the first multiplexer, and send a second control signal to the second-stage sub-ADC, where the first control signal indicates the first-stage sub-ADC to perform m-bit analog-to-digital conversion, and m is a positive integer less than or equal to a maximum processing bit width M of the first-stage sub-ADC; the first selection signal indicates the first multiplexer to select a signal that is input through a first input end; the second control signal indicates the second-stage sub-ADC to perform N-bit analog-to-digital conversion, and N is a maximum processing bit width of the second-stage sub-ADC; M is a positive integer, and N is a positive integer; and the first bit width indication signal is for representing that a processing bit width of the ADC is m+N;
the first-stage sub-ADC is configured to: perform analog-to-digital conversion on a first input analog signal based on the received first control signal and a first reference analog signal, to generate an m-bit digital signal, and send the m-bit digital signal to the digital control module; correct the first input analog signal based on the m-bit digital signal, to generate the first corrected input analog signal; and send the first corrected input analog signal to the first input end of the first multiplexer;
the first multiplexer is configured to: receive the first corrected input analog signal from the first-stage sub-ADC through the first input end, and receive the first input analog signal through a second input end; and when receiving the first selection signal, select, based on the first selection signal, the signal that is input through the first input end as a second input analog signal;
the first interstage amplifier is configured to: amplify the received second input analog signal, and send a signal obtained by amplifying the second input analog signal to the second-stage sub-ADC;
the second-stage sub-ADC is configured to: perform analog-to-digital conversion on the second input analog signal based on a second reference analog signal, to generate an N-bit digital signal, and send the N-bit digital signal to the digital control module; and
the digital control module is configured to: perform correction control on the received m-bit digital signal and the received first N-bit digital signal, to generate an (m+N)-bit output digital signal.

According to this solution, based on the received first bit width indication signal, the low-power control module in the ADC may adjust a real-time processing bit width of the first-stage sub-ADC to m, and control a real-time processing bit width of the second-stage sub-ADC to be the maximum processing bit width N to normally perform analog-to-digital conversion. According to this method, the ADC may adjust the real-time processing bit width of the ADC to m+N based on the first bit width indication signal. Therefore, a preceding-stage module may send the first bit width indication signal to the ADC based on an amplitude of service data or another case, to adjust the processing bit width of the ADC. In this way, power consumption of the ADC is reduced after the processing bit width of the ADC is reduced.

In a possible design, the low-power control module is further configured to: based on a received second bit width indication signal, send a third control signal to the first-stage sub-ADC, send a second selection signal to the first multiplexer, and send a fourth control signal to the second-stage sub-ADC, where the third control signal indicates the first-stage sub-ADC to skip performing analog-to-digital conversion on the first input analog signal; the second selection signal indicates the first multiplexer to select a signal that is input through the second input end; the fourth control signal indicates the second-stage sub-ADC to perform n-bit analog-to-digital conversion, where n is a positive integer less than or equal to N; and the second bit width indication signal is for representing that a processing bit width of the ADC is n;
the first-stage sub-ADC is further configured to: skip performing analog-to-digital conversion on the first input analog signal based on the received third control signal;
the first multiplexer is further configured to: select, based on the second selection signal, the first input analog signal that is input through the second input end as a third input analog signal;
the first interstage amplifier is further configured to: amplify the received third input analog signal, and send a signal obtained by amplifying the third input analog signal to the second-stage sub-ADC;
the second-stage sub-ADC is further configured to: perform analog-to-digital conversion on the third input analog signal based on the second reference analog signal, to generate an n-bit digital signal, and send the n-bit digital signal to the digital control module; and
the digital control module is further configured to: perform correction control on the received first n-bit digital signal, to generate an n-bit output digital signal.

According to this design, based on the received second bit width indication signal, the low-power control module in the ADC may control the first-stage sub-ADC not to operate, and control the real-time processing bit width of the second-stage sub-ADC to be adjusted to n. According to this method, the ADC may adjust the real-time processing bit width of the ADC to n based on the second bit width indication signal. Therefore, the preceding-stage module may send the second bit width indication signal to the ADC based on an amplitude of service data or another case, to adjust the processing bit width of the ADC. In this way, the power consumption of the ADC is reduced after the processing bit width of the ADC is reduced.

In a possible design, the first bit width indication signal is a first bit sequence of H bits, and the second bit width indication signal is a second bit sequence of H bits, where 2^{H} is greater than or equal to M+N; and a decimal value of the first bit sequence is equal to m+N, and a decimal value of the second bit sequence is equal to n.

In a possible design, the first bit width indication signal or the second bit width indication signal is generated by a preceding-stage module of the ADC based on service data of a specified granularity, and the service data of the specified granularity is a single piece of sampled data, or service data received within specified time.

In a possible design, the value of the first reference analog signal is the same as a value of the second reference analog signal; or a value of the second reference analog signal is equal to the value of the first reference analog signal×1/2^{K}, where K is a positive integer less than or equal to M; and an operation parameter of the first interstage amplifier is set based on the value of the first reference analog signal and the value of the second reference analog signal.

According to a third aspect, an embodiment of this application provides an active module. Optionally, the active module may be a component or an apparatus that consumes electric energy, such as a PA, a chip, an ADC, a DAC, or an ASIC. Optionally, the active module includes a low-power control module LPC and a plurality of functional modules. The LPC is configured to control, based on a received first indication signal, all functional modules to operate normally; or control, based on a received second indication signal, all functional modules to stop operating; or control, based on a received third indication signal, a first functional module to operate normally and a second functional module to stop operating. In addition, the LPC may further control a power supply module to stop supplying power to the functional module that stops operating.

According to this solution, through setting the LPC, an operation mode of the active module may be controlled and adjusted, so that the active module can switch between a no-load mode, a low-load mode, and a standard load mode. In this way, a waste of power consumption caused by continuous operation of the active module in the standard load mode can be avoided.

According to a fourth aspect, an embodiment of this application further provides a chip. The chip includes the ADC provided in the first aspect or the second aspect, or includes the active module provided in the third aspect.

According to a fifth aspect, this application further provides a signal processing apparatus. The apparatus includes the ADC provided in the first aspect or the second aspect, or includes the active module provided in the third aspect.

According to a sixth aspect, this application further provides a signal processing system. The system includes a processing unit, and the ADC provided in the first aspect or the second aspect or the active module provided in the third aspect.

According to a seventh aspect, this application further provides an electronic device (for example, a communication device such as a base station). The electronic device includes the ADC provided in the first aspect or the second aspect, or includes the active module provided in the third aspect.

### BRIEF DESCRIPTION OF DRAWINGS

FIG. 1A is an example diagram of statistics on a bit width proportion of service data when a base station is in a full-load state according to this application;
FIG. 1B is an example diagram of statistics on a bit width proportion of service data when a base station is in a low-load state according to this application;
FIG. 2 is a flowchart of basic operation processing of an ADC according to this application;
FIG. 3 is a diagram of a basic structure and an operation principle that are of an ADC according to this application;
FIG. 4 is an example diagram of operation of a 3-bit ADC according to this application;
FIG. 5 is a diagram of an ADC architecture of multi-stage sub-ADCs according to this application;
FIG. 6 is an example diagram of signal amplitude statistics in different system bandwidth scenarios according to this application;
FIG. 7 is a diagram of a structure of an ADC according to an embodiment of this application;
FIG. 8 is a diagram of a structure of an ADC according to an embodiment of this application;
FIG. 9 is a diagram of a structure of an LPC according to an embodiment of this application;
FIG. 10 is a diagram of a structure of an LPC according to an embodiment of this application;
FIG. 11 is a diagram of a structure of an LPC according to an embodiment of this application;
FIG. 12 is a diagram of a structure of an ADC according to an embodiment of this application;
FIG. 13 is a diagram of a structure of a conventional two-stage pipeline-ADC;
FIG. 14 is a diagram of a structure of a two-stage pipeline-ADC instance according to an embodiment of this application;
FIG. 15 is a diagram of a pin of a two-stage pipeline-ADC instance according to an embodiment of this application;
FIG. 16 is a diagram of a structure of a two-stage pipeline-ADC instance according to an embodiment of this application;
FIG. 17 is a diagram of a structure of a two-stage pipeline-ADC instance according to an embodiment of this application;
FIG. 18 is a diagram of a structure of a two-stage pipeline-ADC instance according to an embodiment of this application;
FIG. 19 is a diagram of an ADC architecture with processing bit widths of a plurality of specifications according to an embodiment of this application;
FIG. 20 is a diagram of processing bit widths of a plurality of specifications of a two-stage pipeline-ADC according to an embodiment of this application;
FIG. 21 is a diagram of processing bit widths of a plurality of specifications of a three-stage pipeline-ADC according to an embodiment of this application;
FIG. 22 is a diagram of a structure of an ADC according to an embodiment of this application;
FIG. 23 is a diagram of a structure of an ADC according to an embodiment of this application;
FIG. 24 is a diagram of different time units according to an embodiment of this application;
FIG. 25 is a diagram of an operation mode of an active module according to an embodiment of this application;
FIG. 26 is a diagram of a structure of an active module according to an embodiment of this application;
FIG. 27 is a diagram of an active module in a standard load mode according to an embodiment of this application;
FIG. 28 is a diagram of an active module in a no-load mode according to an embodiment of this application;
FIG. 29 is a diagram of an active module in a low-load mode according to an embodiment of this application;
FIG. 30 is a diagram of a structure of a conventional flash ADC;
FIG. 31 is a diagram of a structure of a flash ADC according to an embodiment of this application;
FIG. 32 is a diagram of a structure of a flash ADC according to an embodiment of this application;
FIG. 33 is a diagram of a structure of a flash ADC according to an embodiment of this application;
FIG. 34 is a diagram of a structure of a pipeline-ADC according to an embodiment of this application;
FIG. 35 is a diagram of a structure of a pipeline-ADC according to an embodiment of this application; and
FIG. 36 is a diagram of a structure of a pipeline-ADC according to an embodiment of this application.

### DESCRIPTION OF EMBODIMENTS

This application provides an ADC and a signal processing apparatus, to implement an ADC whose processing bit width can be adjusted, so that power consumption of the ADC can be reduced.

It should be noted that, a link and a connection described in embodiments of this application may be a direct connection, or may be a connection via at least one component. For example, that A is connected to B (in other words, A is linked with B) may indicate that A is directly connected to B, or A is connected to B via C. In addition, "and/or" describes an association relationship between associated objects, and indicates that three relationships may exist. For example, A and/or B may indicate the following cases: Only A exists, both A and B exist, and only B exists. The character "/" generally indicates an "or" relationship between the associated objects.

It should be noted that, "a plurality of" in this application refers to two or more. "At least one" refers to one or more. "At least one item (piece) of the following" or a similar expression thereof means any combination of these items (pieces), including a singular item (piece) or any combination of plural items (pieces).

In addition, it should be understood that, in description of this application, words such as "first" and "second" are merely used for distinguishing descriptions, but should not be understood as indicating or implying relative importance, or should not be understood as indicating or implying a sequence.

Before embodiments of this application are described, an ADC is first briefly described.

The ADC is used as an active component, and power consumption of the ADC is an important part of total power consumption of an electronic device. That the electronic device is a base station is used for description. Compared with a conventional base station, currently, a base station (for example, a 5G base station) includes a large quantity of baseband processing units and radio frequency active components. This greatly increases power consumption of the base station in a low-load state and a no-load state. During normal power-on running of the base station, power consumption of the base station during service off-peak hours (for example, in the early morning or at night) is not significantly reduced compared with that during service peak hours. This indicates that most of power consumption of the base station has no positive impact on user experience and is invalid. Therefore, if the power consumption of the base station in the low-load state and the no-load state can be reduced, great commercial values and social contribution is generated.

In a mobile communication system, a base station is a device that consumes much power. Inside the base station, power consumption of an active antenna unit (active antenna unit, AAU) accounts for a majority of total power consumption of the base station. The AAU includes a plurality of active components, and includes an ADC. Reducing power consumption of the ADC when the base station is in the low-load state and the no-load state has a positive impact on reducing the power consumption of the base station.

With evolution of the mobile communication system, a frequency band supported by the mobile communication system is increasingly high, and signal bandwidth is also increasingly large. Therefore, an ADC rate requirement is increasingly high. A processing bit width of the ADC, as an important indicator closely coupled with an ADC rate, has a significant impact on the power consumption of the ADC. Therefore, the power consumption of the ADC can be reduced by reducing the processing bit width of the ADC when the base station is in the low-load state and the no-load state, so that the power consumption of the base station can be reduced.

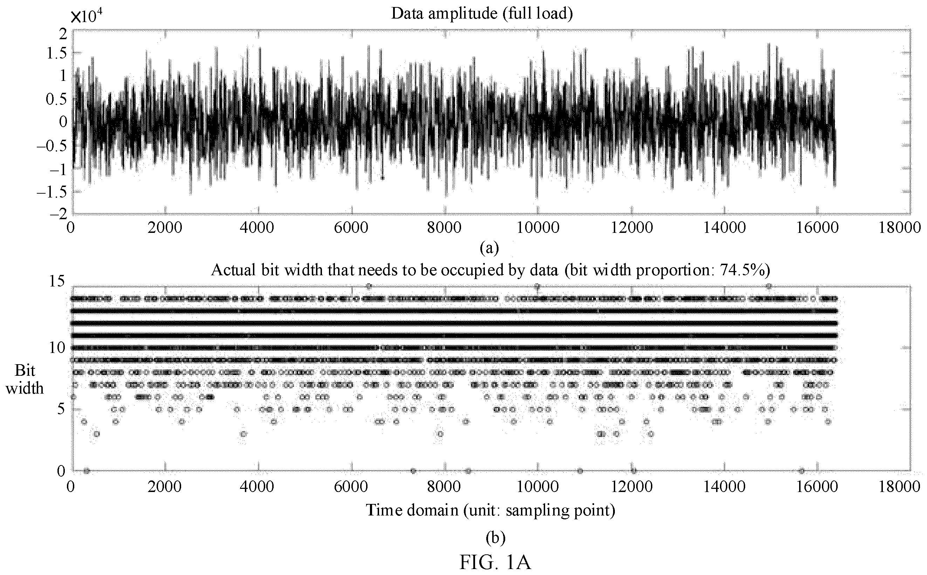

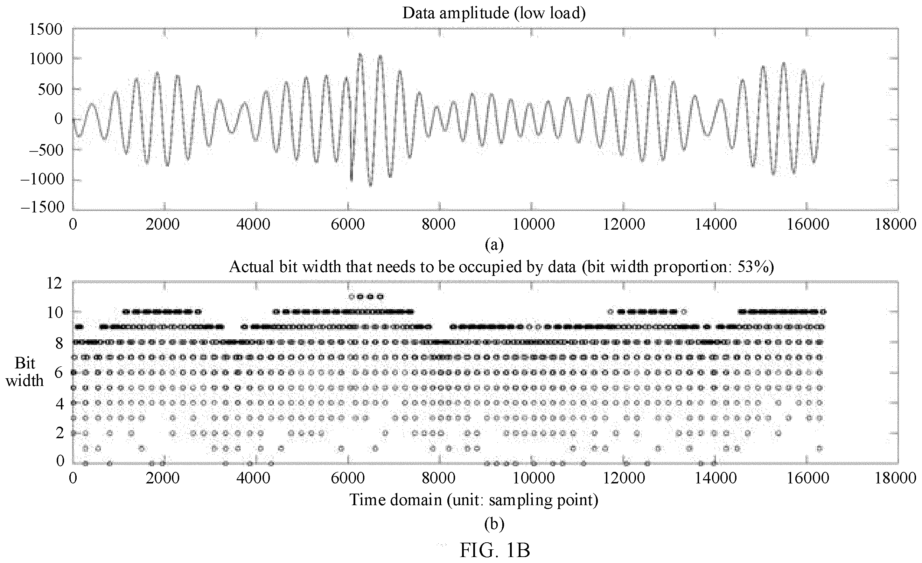

For example, currently, a data bit width of a 5G base station is about 16 bits. In other words, a processing bit width of an ADC in the base station is required to be 16 bits. FIG. 1A and FIG. 1B show statistics on bit width proportions of service data when a base station is in a full-load state and a low-load state.

(a) in FIG. 1A is a curve of a data amplitude of the service data when the base station is in the full-load state, and (b) in FIG. 1A is a data bit width that is actually required by the service data and that is determined based on the data amplitude of the service data in (a) in FIG. 1A. As shown in the figure, in this case, the bit width proportion of the service data is 74.5%.

(a) in FIG. 1B is a curve of a data amplitude of the service data when the base station is in the low-load state, and (b) in FIG. 1B is a data bit width that is actually required by the service data and that is determined based on the data amplitude of the service data in (a) in FIG. 1B. As shown in the figure, in this case, the bit width proportion of the service data is 53%.

It can be learned from data analysis in FIG. 1A and FIG. 1B that, in an actual service processing process of the base station, bit width utilization is not high. However, to ensure standardization and consistency, a processing bit width of a conventional ADC is preset, and the processing bit width cannot be adaptively adjusted. Consequently, real-time service data processed by the conventional ADC does not match a processing resource provided by the ADC, resulting in costs of additional power consumption of the ADC.

Therefore, designing a solution in which the processing bit width of the ADC can be adaptively adjusted is a problem that urgently needs to be resolved in this field.

The following describes a basic operation procedure of an ADC.

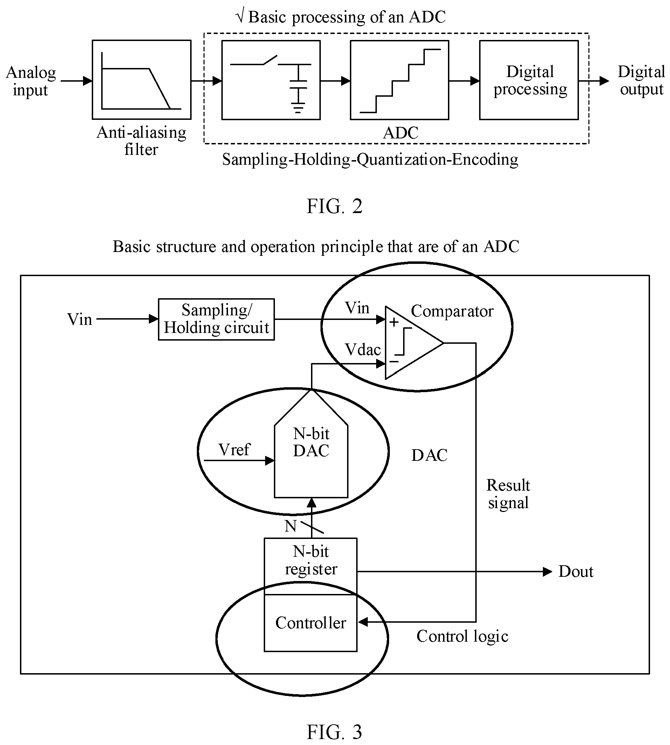

As shown in FIG. 2, the basic operation procedure of the ADC includes steps such as sampling, holding, quantization, and encoding. A basic structure and an operation principle that are of the ADC are shown in FIG. 3. Assuming that a processing bit width of the ADC is N, an N-bit register in the ADC is configured to temporarily store an N-bit sequence, and in an initial state, a most significant bit (most significant bit, MSB) to a least significant bit (least significant bit, LSB) are all low levels (namely, 0).

S1: After a to-be-processed input analog signal (which may be denoted as Vin) is input to the ADC, the to-be-processed input analog signal is first held by a sampling/holding circuit, and the sampling/holding circuit transmits Vin to a first input end of a comparator.

S2: A controller sets a comparison bit of the N-bit register to a high level (that is, set to 1). It should be noted that, in the initial state, the comparison bit of the N-bit register is the most significant bit MSB. In this case, the N-bit sequence currently temporarily stored in the N-bit register changes from a bit sequence in which N bits are all 0s to a bit sequence in which a most significant bit is 1 and other bits are 0s.

S3: A digital-to-analog converter (digital-to-analog converter, DAC) performs, based on a reference analog signal (Vref), digital-to-analog conversion on the N-bit sequence currently temporarily stored in the N-bit register, to obtain a comparison analog signal Vdac, and transmits Vdac to a second input end of the comparator. In this case, because the most significant bit of the N-bit sequence is 1 (where the other bits are 0s), Vdac=Vref/2.

S4: The comparator compares Vin that is input through the first input end with Vdac that is input through the second input end, outputs a result signal based on a comparison result between Vin and Vdac, and transmits the result signal to the controller. The result signal is a high level (namely, 1) or a low level (namely, 0), that is, a 1-bit digital signal. If Vin≥Vdac, the result signal output by the comparator is the high level. If Vin<Vdac, the result signal output by the comparator is the low level.

S5: After receiving the result signal of the current comparison bit, the controller updates a value of the current comparison bit of the N-bit register based on the result signal. To be specific, if the result signal is the high level (1), the current comparison bit remains unchanged; or if the result signal is the low level (0), the current comparison bit is restored to the low level (that is, the current comparison bit is cleared to 0). Then, the controller uses a next bit of the N-bit register as a comparison bit, and repeatedly performs S2 to S5 until the controller updates a result signal of the LSB to the N-bit register.

S6: After the foregoing process is performed, the N-bit register outputs the temporarily stored N-bit sequence in a serial or parallel manner, where the N-bit sequence is an N-bit output digital signal (namely, Dout) output by the ADC.

From a perspective of power consumption, as an analog-to-digital conversion unit and an analog circuit module that are in the ADC, the comparator occupies large power consumption of the ADC in an operation process of the ADC.

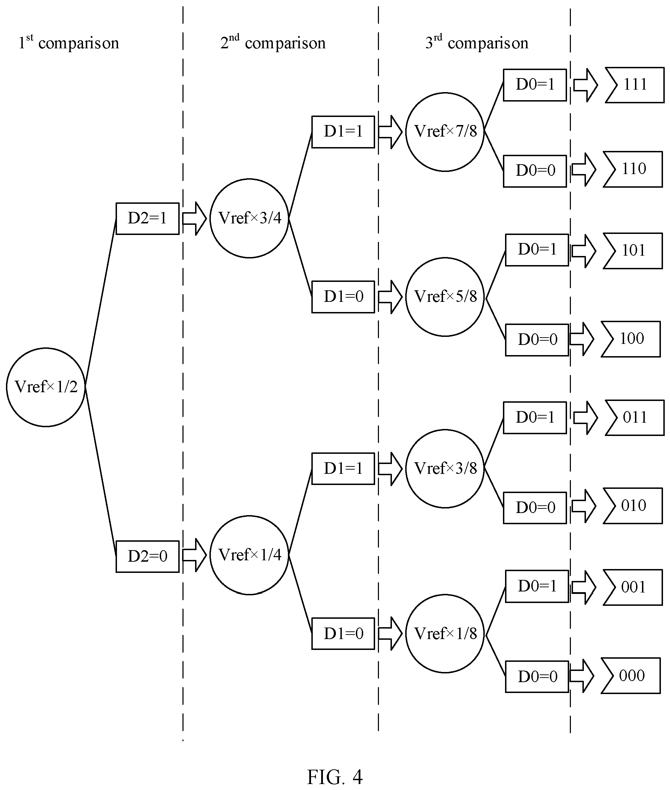

FIG. 4 is an example diagram of operation of a 3-bit ADC. In FIG. 4, a circle is Vdac during each comparison, D2 is a most significant bit of a 3-bit sequence, D1 is a 2^{nd} bit of the 3-bit sequence, and D0 is a least significant bit of the 3-bit sequence. It is clear that, it can be learned from the foregoing operation principle of the ADC and the example shown in FIG. 4 that, a value of the processing bit width of the ADC is equal to a quantity of times of data comparison in the ADC.

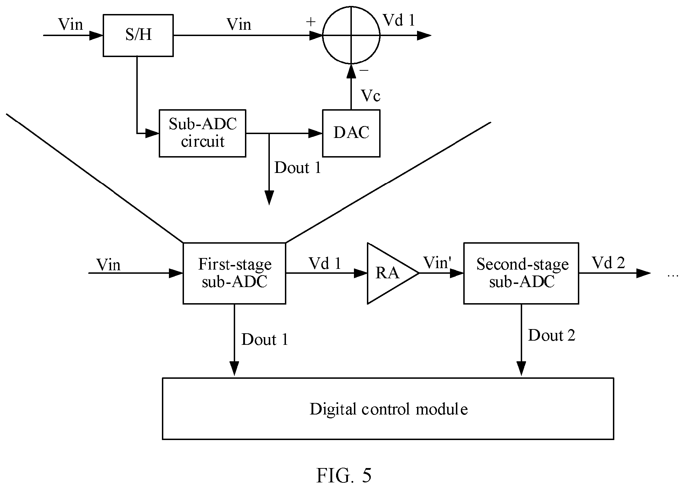

Based on the operation principle of the ADC shown in FIG. 3, to extend the processing bit width of the ADC, currently, an ADC architecture of multi-stage sub-ADCs is provided in the field of circuits. Refer to FIG. 5. The multi-stage sub-ADCs in the ADC are connected in series. A sub-ADC of each stage is configured to perform at least one bit analog-to-digital conversion on an input analog signal based on a processing bit width of a sub-ADC of each stage. The processing bit width of the ADC is a superposition of processing bit widths of the multi-stage sub-ADCs. Processing bit widths of sub-ADCs of different stages may be the same or may be different. This is not limited in this application.

A circuit structure of the sub-ADC of each stage includes a sampling/holding circuit (namely, S/H in FIG. 3) and a sub-ADC circuit, and further includes a differential circuit, as shown in a first-stage sub-ADC in FIG. 5. The following uses the first-stage sub-ADC as an example to describe functions of each circuit module in a circuit structure of the first-stage sub-ADC.

The sampling/holding circuit is configured to sample and hold an analog signal (namely, Vin) that is input to the first-stage sub-ADC.

It is assumed that a processing bit width of the first-stage sub-ADC is N, where N is a positive integer. The sub-ADC circuit is configured to perform N-bit analog-to-digital conversion on the input analog signal (Vin), to generate an N-bit digital signal (Dout 1). For a structure and an operation principle that are of the sub-ADC circuit, refer to FIG. 3. Details are not described herein again.

The differential circuit is configured to perform, based on the N-bit digital signal (Dout 1) obtained by the sub-ADC circuit, differential processing on the analog signal (Vin) that is input to the first-stage sub-ADC. As shown in FIG. 3, the differential circuit may include a DAC and an operational amplifier. The DAC is configured to perform digital-to-analog conversion on the N-bit digital signal (Dout 1) obtained by the sub-ADC circuit, to obtain a correction analog signal (Vc). The operational amplifier is configured to subtract the correction analog signal (Vc) from the input analog signal (Vin), to obtain a differential signal (Vd 1). The differential signal may also be referred to as a corrected analog signal.

A signal obtained by amplifying, by an interstage amplifier (namely, an RA in FIG. 3), a differential signal obtained by a preceding-stage sub-ADC is used as an analog signal (Vin') that is input to a next-stage sub-ADC.

Finally, a digital control module may receive digital signals from the sub-ADCs of the stages, perform processing such as timing alignment and redundancy correction control on the digital signals, and combine the digital signals into an input digital signal (Dout).

It is assumed that the ADC includes two-stage sub-ADCs. A processing bit width of a first-stage sub-ADC is N, a processing bit width of a second-stage sub-ADC is M. In this case, after the first-stage sub-ADC performs N-bit analog-to-digital conversion on an input analog signal, an N-bit digital signal (Dout 1) is obtained; and after the second-stage sub-ADC performs M-bit analog-to-digital conversion on an input analog signal, an M-bit digital signal (Dout 2) is obtained. After receiving Dout 1 and Dout 2, the digital control module performs processing such as timing alignment and redundancy correction on Dout 1 and Dout 2, and combines Dout 1 and Dout 2 into an (N+M)-bit digital signal.

Optionally, the ADC architecture shown in FIG. 5 is applicable to various types of ADCs. For example, a pipeline-ADC (namely, Pipeline-ADC), a pipeline-successive approximation register (shift arithmetic right, SAR) ADC (namely, a Pipeline-SAR ADC), and the like are all designed by using the ADC architecture shown in FIG. 5.

In the ADC architecture shown in FIG. 5, to ensure standardization and consistency, the processing bit width of the sub-ADC of each stage is fixed, and the processing bit width of the entire ADC is also fixed. However, it can be learned by collecting statistics on analog signals in a mobile communication system that, a proportion of sampling points of small-amplitude signals obtained after the analog signals are quantized is large.

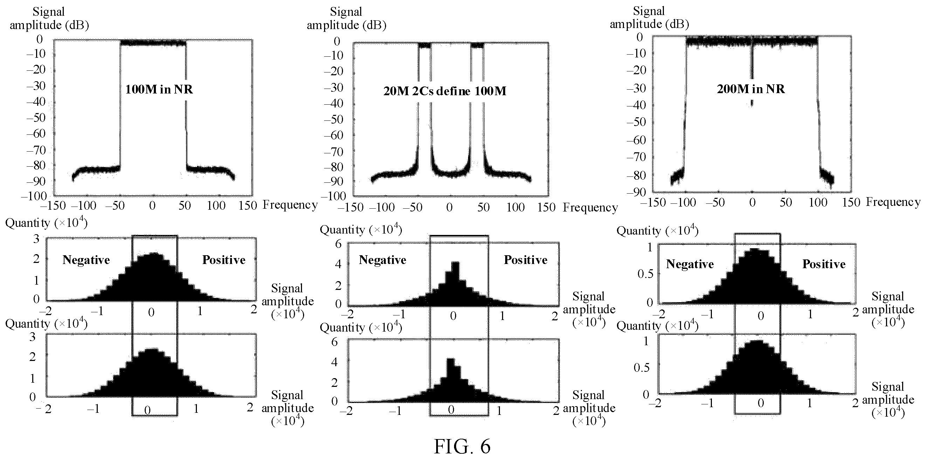

FIG. 6 is used as an example for description. In FIG. 6, a 1^{st} row is diagrams of statistics of signal amplitudes corresponding to different frequencies in different system bandwidth scenarios in a mobile communication system. A horizontal axis of each diagram is frequency distribution, and a vertical axis is a signal amplitude. A 2^{nd} row is distribution of histograms of amplitudes of I signals in different system bandwidth scenarios, and a 3^{rd} row is distribution of histograms of amplitudes of Q signals in different system bandwidth scenarios. In the 2^{nd} row and the 3^{rd} row, a horizontal axis of each diagram is a signal amplitude, and a vertical axis is a quantity of signal sampling points.

It can be learned from diagrams in the 2^{nd} row and the 3^{rd} row in FIG. 6 that, a signal amplitude closer to 0 indicates a larger quantity of signal sampling points. In FIG. 6, signal sampling points in each black box account for a large proportion of entire signal sampling points.

In the mobile communication system, signals with low signal amplitudes account for a high proportion. If an ADC in a communication device still processes the signals by using a fixed processing bit width, the ADC generates some additional power consumption costs.

The following describes in detail embodiments of this application with reference to accompanying drawings.

### Embodiment 1

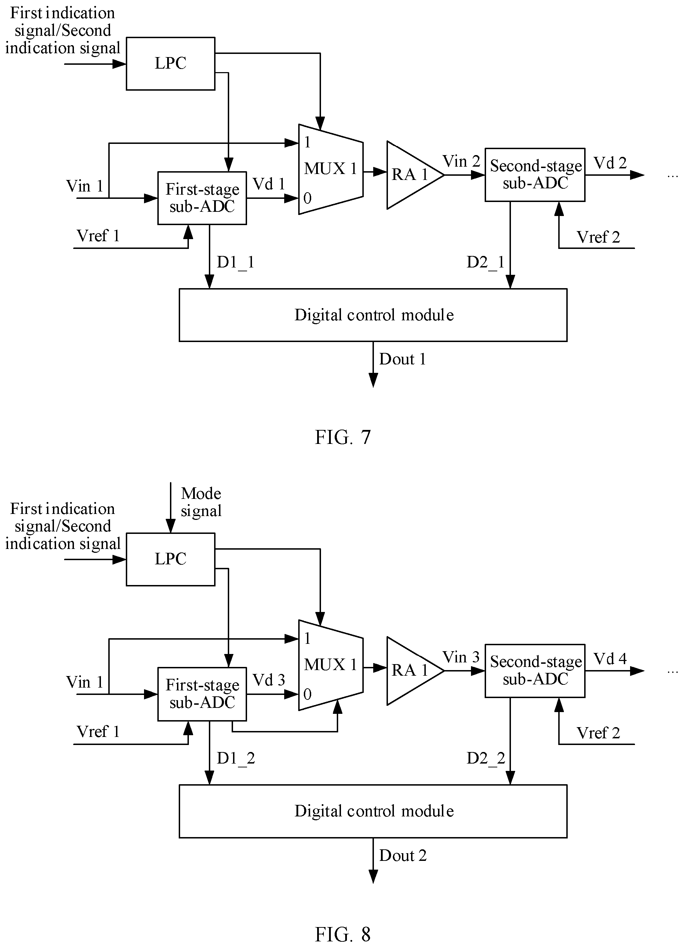

To implement adaptive adjustment to a processing bit width by an ADC for reducing power consumption of the ADC, based on the ADC architecture shown in FIG. 5, an embodiment of this application provides an ADC. Refer to FIG. 7. The ADC includes: a first-stage sub-ADC, a second-stage sub-ADC, a first interstage amplifier (namely, an RA 1 in FIG. 7), a digital control module, a low-power control module (low power controller, LPC) (namely, an LPC in FIG. 7), and a first multiplexer (multiplexer, MUX) (namely, a MUX 1 in FIG. 7).

A connection relationship between modules in the ADC is shown in FIG. 7. It should be noted that, a first input end and a second input end of the first multiplexer are respectively connected to the first-stage sub-ADC and a first input analog signal (namely, Vin 1 in FIG. 7), and the first multiplexer is configured to select a signal from the first input end or the second input end, for output. The LPC is connected to the first-stage sub-ADC, and is configured to control an operation state of the first-stage sub-ADC. The LPC is connected to the first multiplexer, and is configured to control the first multiplexer to select a signal from a specific input end, for output.

The following describes functions of the modules in the ADC with reference to FIG. 7. It is assumed that a processing bit width of the first-stage sub-ADC is M, and a processing bit width of the second-stage sub-ADC is N. M is a positive integer, and N is a positive integer.

The low-power control module is configured to: send a first control signal to the first-stage sub-ADC and send a first selection signal to the first multiplexer based on a received first indication signal; or send a second control signal to the first-stage sub-ADC and send a second selection signal to the first multiplexer based on a received second indication signal. The first control signal indicates the first-stage sub-ADC to perform analog-to-digital conversion on a first input analog signal; the first selection signal indicates the first multiplexer to select a signal that is input through the first input end; the second control signal indicates the first-stage sub-ADC to skip performing analog-to-digital conversion on a first input analog signal (namely, Vin 1); and the second selection signal indicates the first multiplexer to select a signal that is input through the second input end.

The first-stage sub-ADC is configured to: when receiving the first control signal, perform analog-to-digital conversion on the first input analog signal (Vin 1) based on the first control signal and a first reference analog signal (namely, Vref 1 in FIG. 7), to generate a first M-bit digital signal (namely, D1_1 in FIG. 7), and send the first M-bit digital signal to the digital control module; correct the first input analog signal based on the first M-bit digital signal (D1_1), to generate the first corrected input analog signal (namely, Vd 1 in FIG. 7); and send the first corrected input analog signal (Vd 1) to the first input end of the first multiplexer.

The first-stage sub-ADC is further configured to: when receiving the second control signal, skip performing analog-to-digital conversion on the first input analog signal based on the second control signal.

The first multiplexer is configured to: receive the first corrected input analog signal (Vd 1) from the first-stage sub-ADC through the first input end, and receive the first input analog signal (Vin 1) through the second input end; when receiving the first selection signal, select, based on the first selection signal, the signal that is input through the first input end as a second input analog signal (namely, Vin 2 in FIG. 7); or when receiving the second selection signal, select, based on the second selection signal, the signal that is input through the second input end as a second input analog signal (Vin 2); and send the second input analog signal (Vin 2) to the first interstage amplifier.

The first interstage amplifier is configured to: amplify the received second input analog signal (Vin 2), and send the second input analog signal (Vin 2) to the second-stage sub-ADC.

The second-stage sub-ADC is configured to: perform analog-to-digital conversion on the second input analog signal (Vin 2) based on a second reference analog signal (namely, Vref 2 in FIG. 7), to generate a first N-bit digital signal (namely, D2_1 in FIG. 7), and send the first N-bit digital signal (D2_1) to the digital control module.

The digital control module is configured to: perform correction control on the received first M-bit digital signal (D1_1) and the received first N-bit digital signal (D2_1), to generate a first (M+N)-bit output digital signal (namely, Dout 1 in FIG. 7); or perform correction control on the received first N-bit digital signal (D2_1), to generate a first N-bit output digital signal (namely, Dout 1 in FIG. 7).

It can be learned from the foregoing solution that, the low-power control module in the ADC may control, based on a received indication signal (the first indication signal or the second indication signal), whether the first-stage sub-ADC in the ADC is to normally perform analog-to-digital conversion. When the first-stage sub-ADC operates, a processing bit width of the ADC is M+N. When the first-stage sub-ADC does not operate, a processing bit width of the ADC is N. Therefore, a preceding-stage module may send the indication signal to the ADC based on an amplitude of service data or another case, to adjust the processing bit width of the ADC. In this way, power consumption of the ADC is reduced after the processing bit width of the ADC is reduced.

In this embodiment of this application, for operation principles, circuit structures, and the like that are of the first-stage sub-ADC and the second-stage sub-ADC, refer to descriptions in FIG. 3 and FIG. 5. Details are not described herein again. A process in which the first-stage sub-ADC corrects the first input analog signal based on the first M-bit digital signal (D1_1), to generate the first corrected input analog signal (Vd 1) is a process in which the first-stage sub-ADC obtains a differential signal by using a differential circuit. For a specific process, refer to descriptions of the differential circuit in FIG. 5.

In an implementation, the low-power control module may have two operation modes. In a first mode, the low-power control module may perform control based on the received first indication signal or the received second indication signal. In a second mode, the low-power control module may enable a mode of adaptively adjusting the processing bit width by the ADC. In this implementation, the first-stage sub-ADC may determine, based on a magnitude of the first input analog signal (Vin 1), whether the first-stage sub-ADC needs to normally perform analog-to-digital conversion. It should be noted that, in this implementation, the first-stage sub-ADC may be connected to the first multiplexer, and is configured to control the first multiplexer to select a signal from a specific input end, for output.

In this implementation, the low-power control module is specifically configured to:
in the first mode, send the first control signal to the first-stage sub-ADC and send the first selection signal to the first multiplexer based on the received first indication signal; or, send the second control signal to the first-stage sub-ADC and send the second selection signal to the first multiplexer based on the received second indication signal. For a subsequent process, refer to FIG. 7.

When the low-power control module is in the second mode, functions and signal processing processes of the modules may be described with reference to FIG. 8.

The low-power control module is further configured to:
in the second mode, send a third control signal to the first-stage sub-ADC, where the third control signal indicates the first-stage sub-ADC to determine, based on the magnitude of the first input analog signal (Vin 1), whether to perform analog-to-digital conversion on the first input analog signal (Vin 1).

The first-stage sub-ADC is further configured to:
compare the first input analog signal (Vin 1) with a specified signal based on the third control signal; and
when the first input analog signal (Vin 1) is greater than the specified signal, perform analog-to-digital conversion on the first input analog signal (Vin) based on the first reference analog signal (Vref 1), to generate a second M-bit digital signal (namely, D1_2 in FIG. 8), and send the second M-bit digital signal (D1_2) to the digital control module; correct the first input analog signal (Vin 1) based on the second M-bit digital signal (D1_2), to generate a second corrected input analog signal (namely, Vd 3 in FIG. 8); send the second corrected input analog signal (Vd 3) to the first input end of the first multiplexer; and send a third selection signal to the first multiplexer, where the third selection signal indicates the first multiplexer to select the signal that is input through the first input end; or
when the first input analog signal is less than the specified signal, skip performing analog-to-digital conversion on the first input analog signal (Vin 1); and send a fourth selection signal to the first multiplexer, where the fourth selection signal indicates the first multiplexer to select the signal that is input through the second input end.

The first multiplexer is further configured to: receive the second corrected input analog signal (Vd 3) from the first-stage sub-ADC through the first input end, and receive the first input analog signal (Vin 1) through the second input end; when receiving the third selection signal, select, based on the third selection signal, the signal (namely, Vd 3) that is input through the first input end as a third input analog signal (namely, Vin 3 in FIG. 8); or when receiving the fourth selection signal, select, based on the fourth selection signal, the signal (namely, Vin 1) that is input through the second input end as a third input analog signal (Vin 3); and send the third input analog signal (Vin 3) to the first interstage amplifier.

The first interstage amplifier is further configured to: amplify the received third input analog signal (Vin 3), and send the third input analog signal (Vin 3) to the second-stage sub-ADC.

The second-stage sub-ADC is further configured to: perform analog-to-digital conversion on the third input analog signal (Vin 3) based on the second reference analog signal (Vref 2), to generate a second N-bit digital signal (namely, D2_2 in FIG. 8), and send the second N-bit digital signal (D2_2) to the digital control module.

The digital control module is further configured to: perform correction control on the received second M-bit digital signal (D1_2) and the received second N-bit digital signal (D2_2), to generate a second (M+N)-bit output digital signal (namely, Dout 2 in FIG. 8); or perform correction control on the received second N-bit digital signal (D2_2), to generate a second N-bit output digital signal (Dout 2).

According to this implementation, when the low-power control module in the ADC is in the second mode, the first-stage sub-ADC in the ADC may determine, based on a magnitude of an input analog signal, whether to normally perform analog-to-digital conversion. When the first-stage sub-ADC operates, a processing bit width of the ADC is M+N. When the first-stage sub-ADC does not operate, a processing bit width of the ADC is N. Therefore, when the low-power control module in the ADC is controlled to be in the second mode, the ADC may adaptively adjust the processing bit width of the ADC based on the magnitude of the analog signal that is input to the ADC. In this way, the power consumption of the ADC is reduced after the processing bit width of the ADC is reduced.

In an implementation, a value of the specified signal is equal to a value of the first reference analog signal (Vref 1)×1/2^{M}.

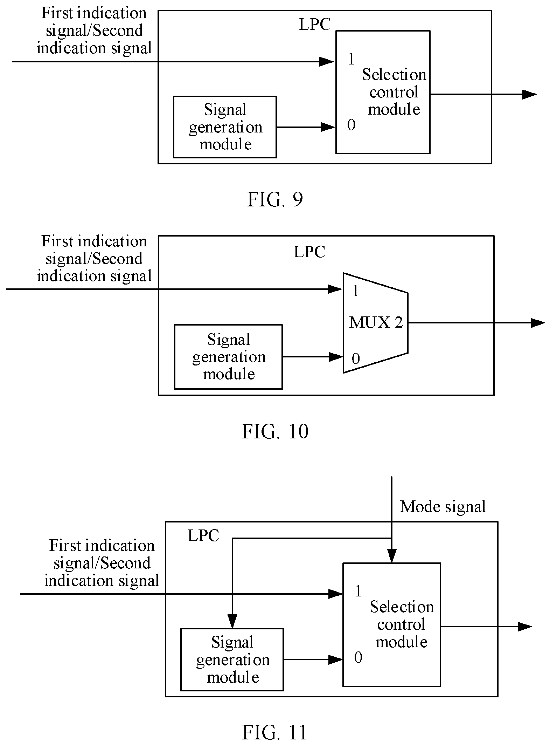

In this embodiment of this application, refer to FIG. 9. The low-power control module may include a selection control module and a signal generation module.

The signal generation module is configured to: when the low-power control module is in the second mode, generate the third control signal.

The selection control module is configured to: receive the first indication signal or the second indication signal through a first input end; and receive the third control signal of the signal generation module through a second input end; and
when the low-power control module is in the first mode, send the first control signal to the first-stage sub-ADC and send the first selection signal to the first multiplexer based on the first indication signal received through the first input end; or send the second control signal to the first-stage sub-ADC and send the second selection signal to the first multiplexer based on the second indication signal received through the first input end; or
when the low-power control module is in the second mode, send the third control signal received through the second input end to the first-stage sub-ADC.

It can be learned from the foregoing descriptions that, the selection control module may generate the first control signal and the first selection signal based on the received first indication signal, or may generate the second control signal and the second selection signal based on the received second indication signal.

For example, the selection control module is a second multiplexer, a structure of the low-power control module is shown in FIG. 10, and the second multiplexer is a MUX 2 in FIG. 10. In this case, a value of the first indication signal, a value of the first control signal, and a value of the first selection signal are the same; or a value of the second indication signal, a value of the second control signal, and a value of the second selection signal are the same. The second multiplexer is configured to: select, in the first mode, a signal that is input through the first input end; or select, in the second mode, a signal that is input through the second input end.

Optionally, the operation mode of the low-power control module may be controlled via a mode signal (LP_mode). In this way, a user or a preceding-stage module of the ADC may control the operation mode of the low-power control module in the ADC by sending the mode signal to the ADC, as shown in FIG. 8. For example, this application further provides a structure of a low-power control module. Refer to FIG. 11. A mode signal is added based on the low-power control module shown in FIG. 9. When the mode signal indicates the first mode, the selection control module selects to perform control based on the first indication signal or the second indication signal that is input through the first input end; or when the mode signal indicates the second mode, the selection control module selects to perform control based on the third control signal that is input through the second input end.

Optionally, as shown in FIG. 11, the signal generation module may trigger operation based on the mode signal. To be specific, when the signal generation module receives the mode signal indicating the first mode, the signal generation module may not generate the third control signal; or when the signal generation module receives the mode signal indicating the second mode, the signal generation module starts to generate the third control signal.

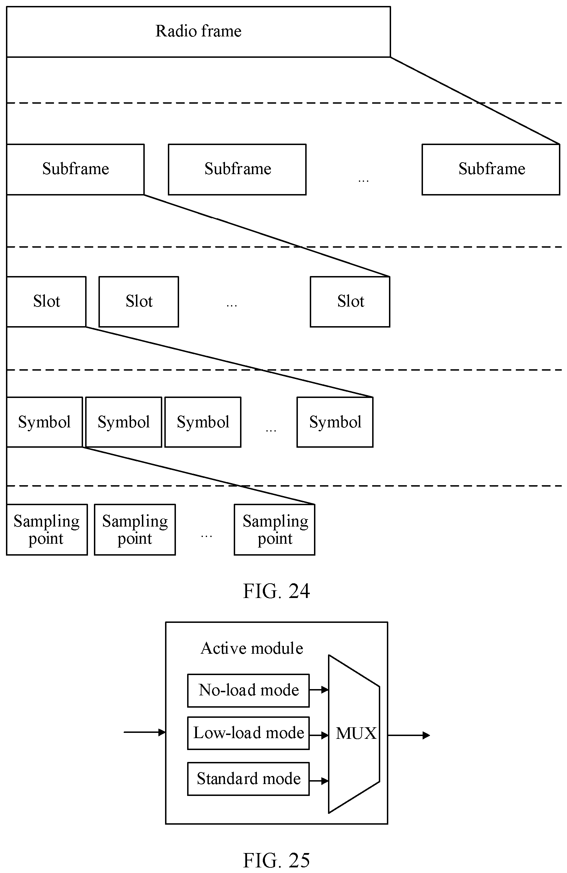

In a possible implementation, the first indication signal or the second indication signal is generated by the preceding-stage module of the ADC based on service data of a specified granularity, and the service data of the specified granularity is a single piece of sampled data, or service data received within specified time. The specified time may include at least one time unit. It should be noted that, a specific form of the time unit is not limited in this application. The time unit may be a time unit in the field of communication, such as a symbol, a slot, a subframe, or a radio frame, or may be a conventional time unit, such as a second, a minute, an hour, or a day. For example, a specific setting form of the specified granularity may be any one of time units shown in FIG. 24.

According to this implementation, the ADC may flexibly adjust the processing bit width based on the service data of the specified granularity. If the specified granularity is smaller, a potential power consumption gain of the ADC is greater.

In a possible implementation, the value of the first reference analog signal (Vref 1) is the same as a value of the second reference analog signal (Vref 2). In other words, the first-stage sub-ADC and the second-stage sub-ADC may use a same reference analog signal to perform analog-to-digital conversion. In this case, the first interstage amplifier may amplify the received signal by 2^{M} times.

In another possible implementation, a value of the second reference analog signal (Vref 2) is equal to the value of the first reference analog signal (Vref 1)×1/2^{K}, where K is a positive integer less than or equal to M; and an operation parameter of the first interstage amplifier is set based on the value of the first reference analog signal and the value of the second reference analog signal.

For example, in comparison with an operation parameter of the first interstage amplifier when Vref 2=Vref 1, when Vref 2=Vref 1/2, a gain of the first interstage amplifier may be reduced by 6 dB in design, and power consumption of the first interstage amplifier can be reduced; when Vref 2=Vref 1/2², a gain of the first interstage amplifier can be reduced by 12 dB in design, and power consumption of the first interstage amplifier can be further reduced; or when Vref 2=Vref 1/2^{M}, the first interstage amplifier may be bypassed (that is, the first interstage amplifier may not operate).

In a possible implementation, a value of the second reference analog signal (Vref 2) is equal to a value of the first reference analog signal (Vref 1)× 1/2^{M}, and the specified signal is the second reference analog signal (Vref 2). In the second mode, the first-stage sub-ADC may compare the input first input analog signal (Vin 1) with the second reference analog signal (Vref 2), to determine whether analog-to-digital conversion needs to be performed on the first input analog signal (Vin 1).

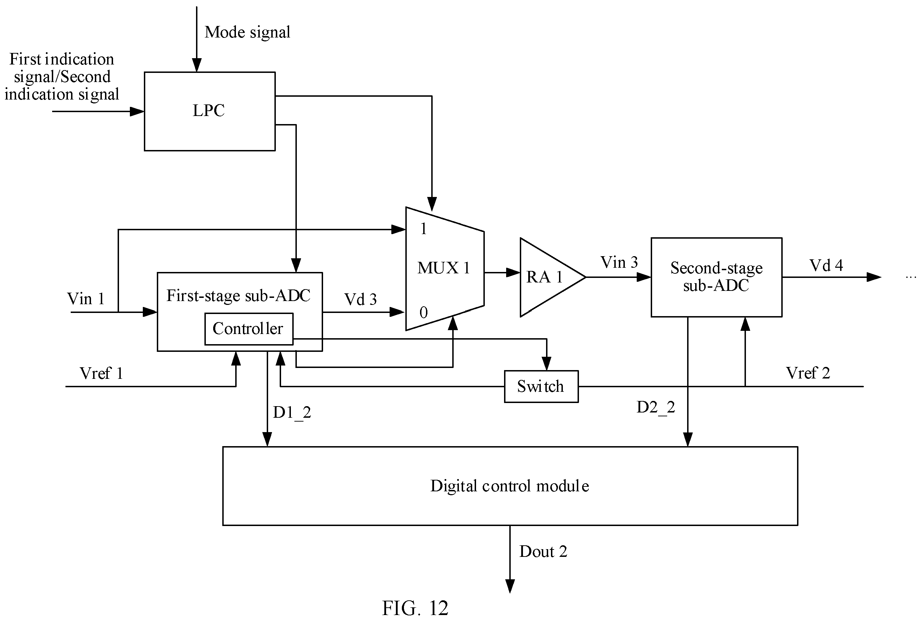

In this implementation, refer to FIG. 12. The first-stage sub-ADC includes a controller, and the controller is configured to: when receiving the third control signal, turn on a switch between the second reference analog signal (Vref 2) and the first-stage sub-ADC, so that the first-stage sub-ADC can receive the second reference analog signal (Vref 2).

It should be further noted that, in comparison with a conventional ADC, an additional pin needs to be added in the ADC provided in this embodiment of this application, to receive the first indication signal or the second indication signal.

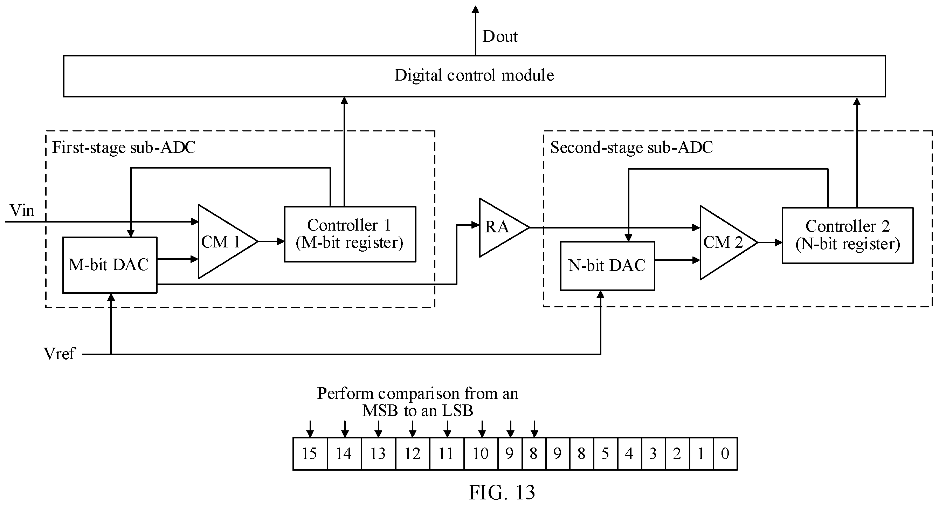

The following uses a two-stage pipeline-ADC as an example for description. Refer to FIG. 13. A structure of a conventional two-stage pipeline-ADC mainly includes two-stage sub-ADCs and an interstage amplifier (RA). For a structure and an operation principle that are of a sub-ADC of each stage, refer to descriptions corresponding to FIG. 3 and FIG. 5. Details are not described herein again. The sub-ADC of each stage includes a DAC, a comparator (CM), and a controller. A register is coupled to the controller.

As shown in FIG. 13, a processing bit width of a first-stage sub-ADC is M. Therefore, the first-stage sub-ADC includes an M-bit DAC, a CM 1, and a controller 1 coupled to an M-bit register. Similarly, a processing bit width of a second-stage sub-ADC is N. Therefore, the second-stage sub-ADC includes an N-bit DAC, a CM 2, and a controller 2 coupled to an N-bit register.

In an operation process of the ADC, the first-stage sub-ADC needs to perform comparison from an MSB to an LSB that are in M bits for M times in total, to obtain an M-bit digital signal. Similarly, the second-stage sub-ADC needs to perform comparison from an MSB to an LSB that are in N bits for N times in total, to obtain an N-bit digital signal. If processing bit widths of the sub-ADCs of the two stages are both 8, each of the two-stage sub-ADCs needs to perform comparison for eight times.

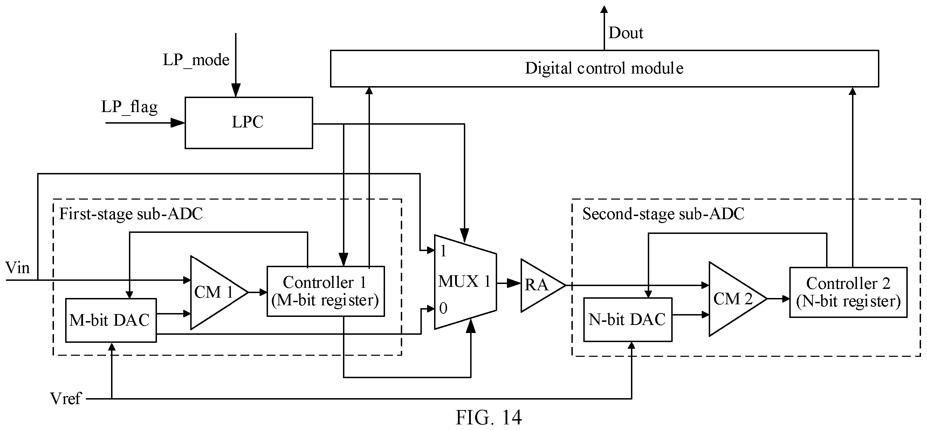

Based on the solution provided in the foregoing Embodiment 1, this application provides an instance 1 of a two-stage pipeline-ADC. Refer to FIG. 14. In comparison with the structure of the conventional two-stage pipeline-ADC in FIG. 13, two modules are newly added in the pipeline-ADC in this instance: a low-power control module (namely, an LPC in FIG. 14) and a first multiplexer (namely, a MUX 1 in FIG. 14). It should be noted that, this instance is used as an example, and does not constitute any limitation on the solution in Embodiment 1. The following is described with reference to FIG. 14.

Input of the LPC is a low-power indication signal (namely, LP_flag in the figure). LP_flag is generated and transmitted by a preceding-stage module of the ADC. Optionally, in a package structure of the ADC, LP_flag may be input through a separate input pin. Output of the LPC is connected to a controller 1 of a first-stage sub-ADC and the MUX 1.

The MUX 1 is located after the first-stage sub-ADC and before the RA. Two input ends of the MUX 1 are respectively configured to input an original input analog signal Vin and a differential signal Vd 1 obtained by correcting Vin by the first-stage sub-ADC, and an output end of the MUX 1 is connected to an input end of the RA.

The following describes functions of two modules: the LPC and the MUX 1.

### (1) LPC

The LPC has two operation modes: a first mode (Mode 1) and a second mode (Mode 0). The operation mode of the LPC is controlled by using an LP mode signal (namely, LP_mode in the figure).

When LP_mode is equal to 1, the operation mode of the LPC is Mode 1. In this case, the LPC directly transparently transmits LP_flag input by the preceding-stage module. When a value of LP_flag is 1, the controller 1 controls the first-stage sub-ADC not to operate (that is, the first-stage sub-ADC does not perform analog-to-digital conversion, and is directly bypassed). When a value of LP_flag is 0, the controller 1 controls the first-stage sub-ADC to operate normally and not to be bypassed (that is, the first-stage sub-ADC normally performs M-bit analog-to-digital conversion).

When LP_mode is equal to 0, the operation mode of the LPC is Mode 0. In this case, the LPC indicates the first-stage sub-ADC to determine, based on a magnitude of Vin, whether the first-stage sub-ADC is to operate (that is, determine whether to perform analog-to-digital conversion). For example, when LP_mode is equal to 0, the LPC sends a control signal to the controller 1. Based on the control signal, the controller 1 controls a least significant bit of an M-bit register to be set to a high level, and then an M-bit DAC may perform, based on a reference analog signal (Vref), digital-to-analog conversion on an M-bit sequence currently temporarily stored in the M-bit register, to obtain a judgment reference signal (Vj). In this case, Vj=Vref/2^{M}.

A CM 1 compares Vj with Vin. If a result signal output by the CM 1 is 1, the controller 1 restores the least significant bit of the M-bit register to a low level, and the first-stage sub-ADC performs a conventional analog-to-digital conversion procedure based on control of the controller 1. For a specific process of the analog-to-digital conversion procedure, refer to the foregoing descriptions in FIG. 3. Details are not described herein again. If a result signal output by the CM 1 is 0, the controller 1 restores the least significant bit of the M-bit register to a low level, and holds each bit of the M-bit register to the low level, to ensure that the first-stage sub-ADC does not perform an analog-to-digital conversion procedure.

It should be noted that, in a scenario in which LP_mode is equal to 0, when the result signal received by the controller 1 from the CM 1 is 1, the controller 1 may further send a selection signal 0 to the MUX 1; or when the result signal received by the controller 1 from the CM 1 is 0, the controller 1 may further send a selection signal 1 to the MUX 1.

### (2) MUX 1

The MUX 1 controls an input signal of the RA based on an output signal of the LPC or a selection signal sent by the controller 1. When the output signal of the LPC or the selection signal sent by the controller 1 is 1, the MUX 1 selects Vin as the input signal of the RA. When the output signal of the LPC or the selection signal sent by the controller 1 is 0, the MUX 1 selects the differential signal (Vd 1) output by the M-bit DAC as the input signal of the RA.

A second-stage sub-ADC normally performs analog-to-digital conversion based on the received analog signal amplified by the RA. A specific process is not described herein again.

A process of generating LP_flag needs to be further described. For example, LP_flag may be generated by the preceding-stage module or a preceding-stage system of the ADC based on real-time service data, and is for assisting in controlling an operation state of a sub-ADC in the ADC.

Optionally, the preceding-stage module or the preceding-stage system may continuously generate LP_flag based on service data of a specified granularity. The service data of the specified granularity is a single piece of sampled data, or service data received within specified time. The specified time may include at least one time unit. The time unit may be a symbol, a slot, a subframe, a radio frame, or the like, or may be a second, a minute, an hour, a day, or the like. This is not limited in this application.

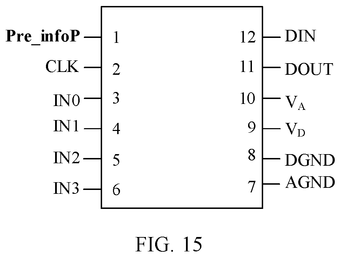

In comparison with a hardware structure of the conventional ADC, a new pin needs to be added in the ADC provided in this embodiment of this application, to receive LP_flag. Refer to FIG. 15. A pin Pre_infoP is configured to receive LP_flag.

According to the solution provided in the foregoing instance, the two-stage pipeline-ADC is used as an example. In this solution, power consumption of each active component in the first-stage sub-ADC can be dynamically reduced. Further, this solution may be extended to a multi-stage pipeline-ADC. If an N-stage pipeline-ADC is designed by using this solution, power consumption of active components in (N-1)-stage sub-ADCs can be reduced at most. A final power consumption gain of this solution is related to probability distribution of signal amplitudes of analog signals processed by the ADC.

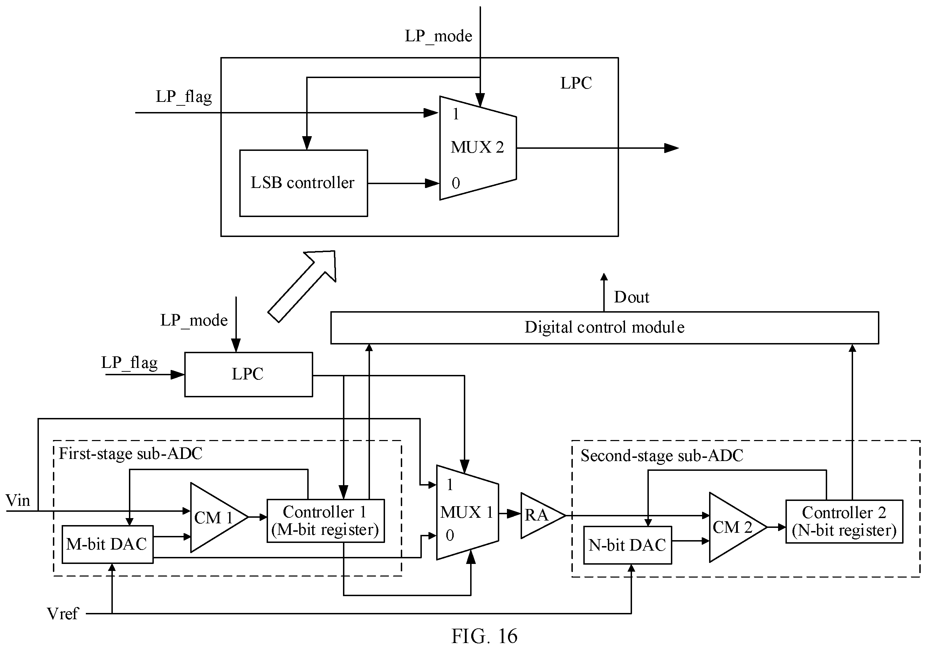

Based on an instance 1 shown in FIG. 14, this application further provides an instance 2 of another two-stage pipeline-ADC. Refer to FIG. 16. This instance provides an internal circuit structure of an LPC. It should be noted that, this instance is used as an example, and does not constitute any limitation on the structure of an LPC.

Similar to FIG. 9 or FIG. 10, in this instance, the LPC may include an LSB controller and a second multiplexer (namely, a MUX 2 in FIG. 16). The LSB controller is for generating a control signal, to indicate a first-stage sub-ADC to determine, based on a magnitude of Vin, whether the first-stage sub-ADC is to operate (that is, whether to perform analog-to-digital conversion). The following describes in detail functions of the LPC with reference to FIG. 16.

Two operation modes of the LPC are controlled by using LP_mode. LP_mode can be transmitted to both the MUX 2 and the LSB controller.

When LP_mode is equal to 1, the LSB controller does not operate, and the MUX 2 directly transparently transmits LP_flag input by a preceding-stage module as an output of the LPC. In this way, the LPC may control, based on LP_flag, whether the first-stage sub-ADC is to operate normally, and control the MUX 1 to select a signal that needs to be output. For the foregoing control process, refer to corresponding descriptions in Embodiment 1. Details are not described herein again.

When LP_mode is equal to 0, the LSB controller starts to operate and outputs the control signal. The MUX 2 directly transparently transmits the control signal as an output of the LPC. In this way, a controller 1 in the first-stage sub-ADC may determine, based on the control signal and the magnitude of Vin, whether the first-stage sub-ADC is to operate (that is, whether to perform analog-to-digital conversion). For processes of how the first-stage sub-ADC determines whether to operate and how to operate, refer to related descriptions in Embodiment 1. Details are not described herein again.

According to the solution provided in this instance, the control signal generated by the LSB controller may be used for controlling to reduce a quantity of times of successive comparison by the ADC. In this way, power consumption of the ADC is reduced.

A two-stage pipeline-ADC is still used for description. If a processing bit width of a sub-ADC of each stage is 8, a processing bit width of the ADC is 16. In a conventional solution, the ADC needs to perform comparison for 16 times. After the solution in this instance is used, if the first-stage sub-ADC determines that Vin<Vj, the ADC needs to perform comparison for only 9 times (where the first-stage sub-ADC performs comparison once, the second-stage sub-ADC performs comparison for 9 times, and 1+8=9 times). Therefore, comparison operations by the ADC can be reduced by 40%+ in the solution in this instance, in comparison with those of a conventional ADC. If a proportion of service data that is less than Vj and that is in the service data processed by the ADC is 30%, comparison operations by the ADC can be reduced by 12% (40%×30%=12%) in this solution.

It should be further noted that, the LPC and the MUX 1 may be connected via a switch. When LP_mode is equal to 0, the LPC or another component may turn off the switch, to avoid a case in which the MUX 1 receives the control signal of the LPC, and consequently selects an incorrect signal for output.

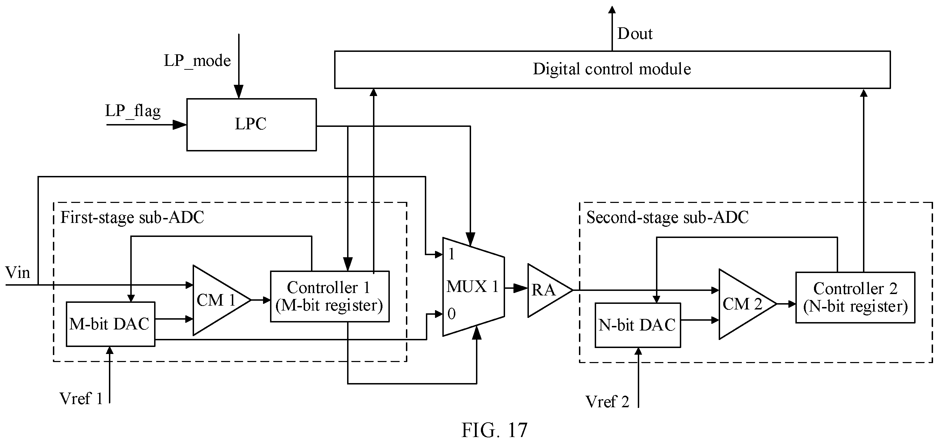

Based on the instance 1 and the instance 2, this application further provides an instance 3. Different from the instance 1 and the instance 2, in the instance 3, two-stage sub-ADCs in a two-stage pipeline-ADC use different reference analog signals. Refer to FIG. 17. A reference analog signal of a first-stage sub-ADC is Vref 1, and a reference analog signal of a second-stage sub-ADC is Vref2.

It can be learned from the foregoing descriptions of the structure of the ADC shown in FIG. 5 that, in the ADC, a preceding-stage sub-ADC performs, based on a digital signal obtained through analog-to-digital conversion, differential processing on an analog signal that is input to the preceding-stage sub-ADC, and a signal obtained by amplifying an obtained differential signal by an interstage amplifier (namely, an RA) is used as an analog signal that is input to a next-stage sub-ADC. If a processing bit width of the preceding-stage sub-ADC is M, the RA may amplify the differential signal by 2^{M} times.

It is clear that, an operation parameter of the RA is related to values of reference analog signals of the two-stage sub-ADCs.

Based on this, in this instance, multi-stage reference analog signals may be introduced, to reduce power consumption of the interstage amplifier RA.

For example, in comparison with an operation parameter of the RA when Vref 2=Vref 1, when Vref 2=Vref 1/2, a gain of the RA may be reduced by 6 dB in design, and the power consumption of the RA can be reduced; when Vref 2=Vref 1/2², a gain of the RA can be reduced by 12 dB in design, and the power consumption of the RA can be further reduced; or when Vref 2=Vref 1/2^{M}, the RA may be bypassed (that is, the RA may not operate. In this case, the ADC may not be provided with an RA component, and the MUX 1 is directly connected to the second-stage sub-ADC.)

The foregoing data is ideal data without considering some errors and losses. Even if some non-ideal conditions are considered, and an additional correction algorithm needs to be introduced to the ADC, the solution in this instance can still have a positive impact on reducing power consumption of the ADC, in comparison with a conventional solution.

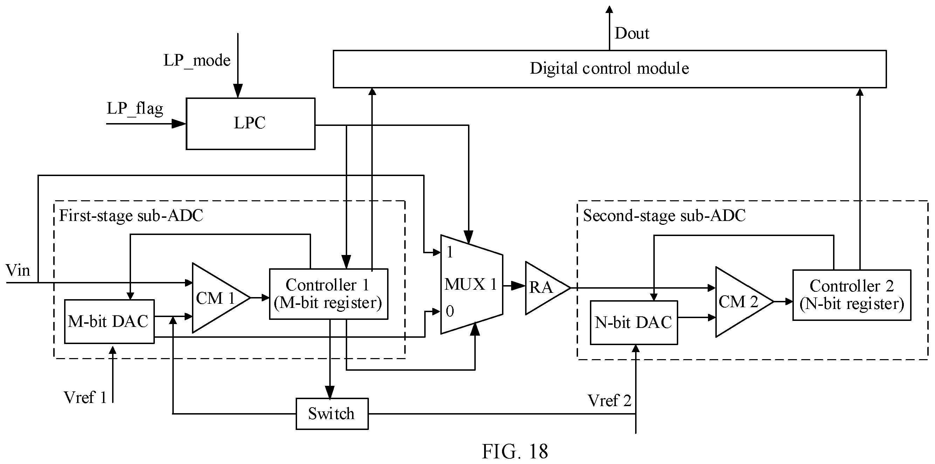

Based on the instance 3, this application further provides an instance 4. In a scenario in which Vref 2=Vref 1/2^{M}, when an operation mode of an LPC is Mode 1, a first-stage sub-ADC may generate a judgment reference signal Vj (Vj=Vref 1/2^{M}) based on a received control signal of an LPC, compare Vj with Vin, and determine, based on a comparison result, whether the first-stage sub-ADC needs to operate. It is clear that, in this scenario, a value of the judgment reference signal Vj is the same as a value of Vref 2. Therefore, in this instance, Vref 2 may be introduced into the first-stage sub-ADC, so that the first-stage sub-ADC does not need to generate Vj through digital-to-analog conversion. In this way, power consumption caused by a case in which a DAC generates Vj in the first-stage sub-ADC is eliminated. Based on the foregoing idea, this application provides an ADC architecture, as shown in FIG. 18.

In this instance, Vref 2 may be connected to a CM 1 via a switch. A controller 1 controls a status of the switch.

When LP_mode is equal to 0, the LPC sends a control signal to the controller 1. The controller 1 closes the switch based on the control signal, so that the CM 1 compares Vref 2 (Vj) with Vin. When a result signal output by the CM 1 is 1, the controller 1 turns off the switch, so that the first-stage sub-ADC can perform a conventional analog-to-digital conversion procedure based on Vref 1 and control of the controller 1.

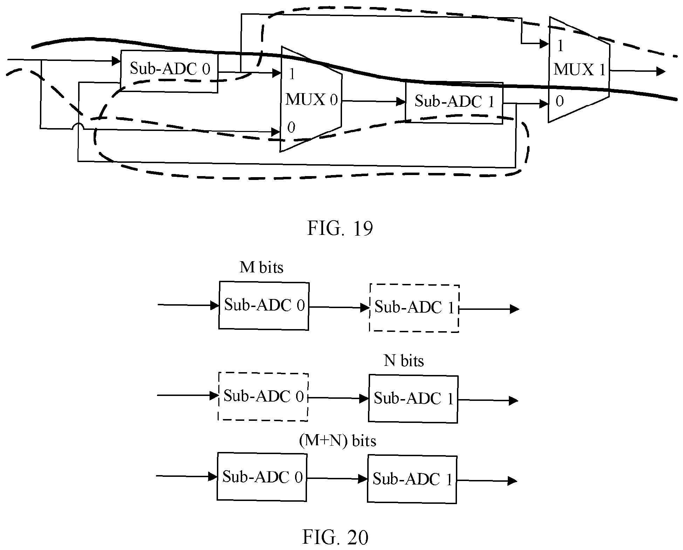

Based on the solutions provided in Embodiment 1 and the instance 1 and the instance 3, this application further provides the instance 4. This instance may provide an architecture of an ADC with processing bit widths of a plurality of specifications. A position of each sub-ADC in the ADC may change. In this way, based on the solutions provided in Embodiment 1 and the instance 1 to the instance 3, the ADC may have the processing bit widths of the plurality of specifications. For example, in the ADC, a multiplexer may be used for implementing a position change of multi-stage sub-ADCs in the ADC. A two-stage pipeline-ADC is still used as an example for description. Connection relationships between two-stage sub-ADCs (namely, a sub-ADC 0 and a sub-ADC 1) and two multiplexers (namely, a MUX 0 and a MUX 1) that are in the ADC are shown in FIG. 19. The ADC may further include a control module. The control module may control output signals of the MUX 0 and the MUX 1, and adjust the relationship between the sub-ADC 0 and the sub-ADC 1. As shown in FIG. 19, when the control module controls the MUX 0 to select an output signal of the sub-ADC 0 as the output signal, and controls the MUX 1 to select an output signal of the sub-ADC 1 as the output signal, the sub-ADC 0 is the first-stage sub-ADC in the ADC, and the sub-ADC 1 is a second-stage sub-ADC in the ADC. In this case, a signal transmission process is shown by a solid line in FIG. 19.

When the control module controls the MUX 0 to select a to-be-processed input analog signal as the output signal, and controls the MUX 1 to select an output signal of the sub-ADC 0 as the output signal, the sub-ADC 1 is the first-stage sub-ADC in the ADC, and the sub-ADC 0 is a second-stage sub-ADC in the ADC. In this case, a signal transmission process is shown by a dashed line in FIG. 19.

It can be learned from the foregoing descriptions that, when the ADC includes the multi-stage sub-ADCs, and processing bit widths of the multi-stage sub-ADCs are different, the ADC may have a plurality of selections of the processing bit widths based on the position change of the sub-ADCs and control of the foregoing solution. A user or the ADC can select an appropriate processing bit width based on an actual requirement.

In an example of the two-stage pipeline-ADC, if a processing bit width of the sub-ADC 0 is M, and a processing bit width of the sub-ADC 1 is N, the ADC may configure processing bit widths of three rules such as M, N, and M+N, as shown in FIG. 20.

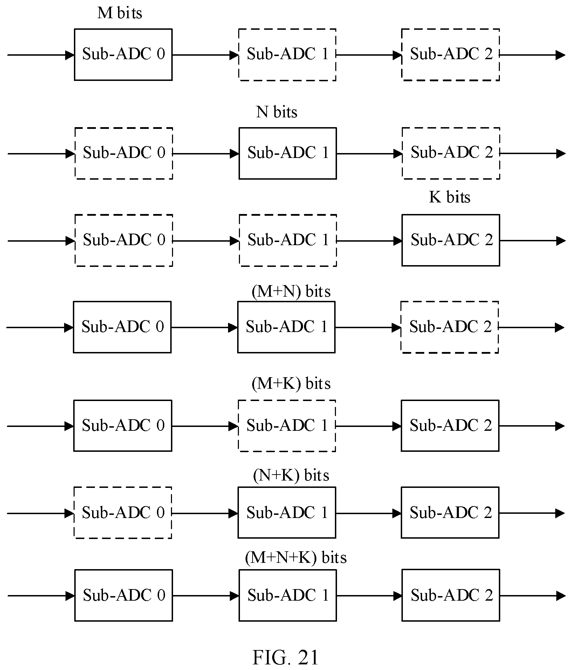

In an example of a three-stage pipeline-ADC, if a processing bit width of a sub-ADC 0 is M, a processing bit width of a sub-ADC 1 is N, and a processing bit width of a sub-ADC 2 is K, the ADC may configure processing bit widths of six rules such as M, N, K, M+N, M+K, N+K, and M+N+K, as shown in FIG. 21.

### Embodiment 2

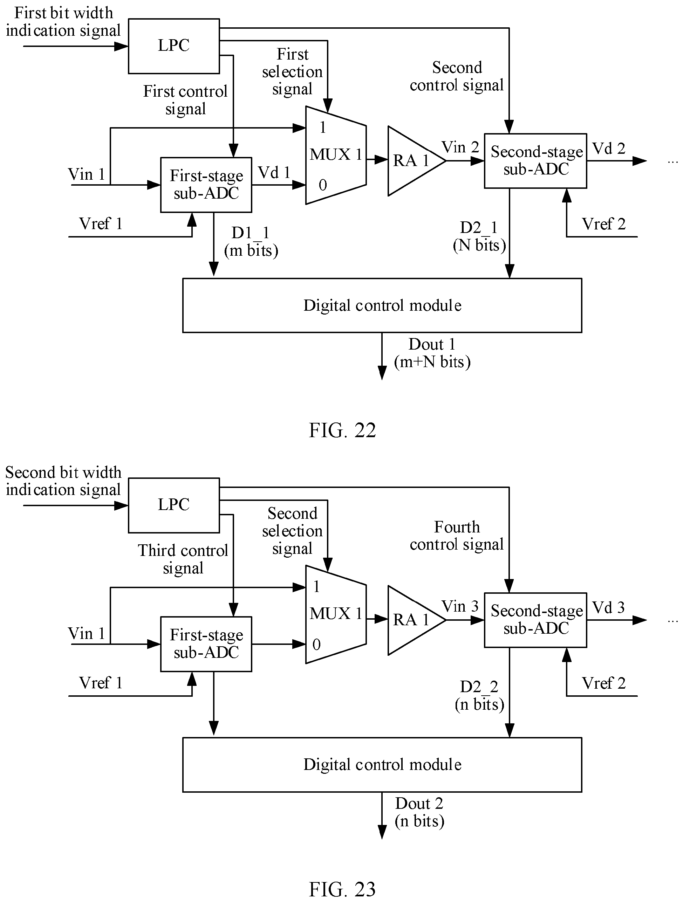

To implement adaptive adjustment to a processing bit width by an ADC for reducing power consumption of the ADC, based on the ADC architecture shown in FIG. 5, an embodiment of this application provides an ADC. Refer to FIG. 22. The ADC includes: a first-stage sub-ADC, a second-stage sub-ADC, a first interstage amplifier (namely, an RA 1 in FIG. 22), a digital control module, a low-power control module (namely, an LPC in FIG. 22), and a first multiplexer (namely, a MUX 1 in FIG. 22).

A connection relationship between modules in the ADC is shown in FIG. 22. It should be noted that, a first input end and a second input end of the first multiplexer are respectively connected to the first-stage sub-ADC and a first input analog signal (namely, Vin 1 in FIG. 22), and the first multiplexer is configured to select a signal from the first input end or the second input end, for output. The LPC is connected to the first-stage sub-ADC and the second-stage sub-ADC, and is configured to control real-time processing bit widths of the first-stage sub-ADC and the second-stage sub-ADC. The LPC is further connected to the first multiplexer. The LPC is connected to the first multiplexer, and is configured to control the first multiplexer to select a signal from a specific input end, for output.

The following describes functions of the modules in the ADC with reference to FIG. 7. It is assumed that a maximum processing bit width of the first-stage sub-ADC is M, and a maximum processing bit width of the second-stage sub-ADC is N. M is a positive integer, and N is a positive integer. That the maximum processing bit width of the first-stage sub-ADC is M indicates that components such as a register and a DAC that are in the first-stage sub-ADC are M bits. That the maximum processing bit width of the second-stage sub-ADC is N indicates that components such as a register and a DAC that are in the second-stage sub-ADC are M bits.

The low-power control module is configured to: based on a received first bit width indication signal, send a first control signal to the first-stage sub-ADC, send a first selection signal to the first multiplexer, and send a second control signal to the second-stage sub-ADC, where the first control signal indicates the first-stage sub-ADC to perform m-bit analog-to-digital conversion, and m is a positive integer less than or equal to the maximum processing bit width M of the first-stage sub-ADC; the first selection signal indicates the first multiplexer to select a signal that is input through the first input end; the second control signal indicates the second-stage sub-ADC to perform N-bit analog-to-digital conversion, and N is the maximum processing bit width of the second-stage sub-ADC; M is a positive integer, and N is a positive integer; and the first bit width indication signal is for representing that a processing bit width of the ADC is m+N.

The first-stage sub-ADC is configured to: perform analog-to-digital conversion on the first input analog signal (namely, Vin 1 in FIG. 22) based on the received first control signal and a first reference analog signal (namely, Vref 1 in FIG. 22), to generate an m-bit digital signal (namely, D1_1 in FIG. 22), and send the m-bit digital signal (D1_1) to the digital control module; correct the first input analog signal (Vin 1) based on the m-bit digital signal (D1_1), to generate the first corrected input analog signal (namely, Vd 1 in FIG. 22); and send the first corrected input analog signal (Vd 1) to the first input end of the first multiplexer.

The first multiplexer is configured to: receive the first corrected input analog signal (Vd 1) from the first-stage sub-ADC through the first input end, and receive the first input analog signal (Vin 1) through the second input end; and when receiving the first selection signal, select, based on the first selection signal, the signal (Vd 1) that is input through the first input end as a second input analog signal (namely, Vin 2 in FIG. 22).

The first interstage amplifier (RA 1) is configured to: amplify the received second input analog signal (Vin 2), and send the second input analog signal (Vin 2) to the second-stage sub-ADC.

The second-stage sub-ADC is configured to: perform analog-to-digital conversion on the second input analog signal (Vin 2) based on a second reference analog signal (namely, Vref 2 in FIG. 22), to generate an N-bit digital signal (namely, D2_1 in FIG. 22), and send the N-bit digital signal (D2_1) to the digital control module.

The digital control module is configured to: perform correction control on the received m-bit digital signal (D1_1) and the received first N-bit digital signal (D2_1), to generate an (m+N)-bit output digital signal (namely, Dout 1 in FIG. 22).

According to this solution, in the first-stage sub-ADC, the real-time processing bit width of the first-stage sub-ADC may be adjusted to m based on the first control signal. It should be noted that, for a process in which the first-stage sub-ADC performs analog-to-digital conversion, refer to the foregoing descriptions in FIG. 3. A difference is that a controller 1 in the first-stage sub-ADC uses a 1^{st} bit of last m bits in an M-bit register as a first comparison bit, and after each comparison is completed, uses a next bit of a current comparison bit as a new comparison bit until comparison on the last m bits is all completed.

It can be learned from the foregoing solution that, based on the received first bit width indication signal, the low-power control module in the ADC may adjust the real-time processing bit width of the first-stage sub-ADC to m, and control the real-time processing bit width of the second-stage sub-ADC to be the maximum processing bit width N to normally perform analog-to-digital conversion. According to this method, the ADC may adjust the real-time processing bit width of the ADC to m+N based on the first bit width indication signal. Therefore, a preceding-stage module may send the first bit width indication signal to the ADC based on an amplitude of service data or another case, to adjust the processing bit width of the ADC. In this way, power consumption of the ADC is reduced after the processing bit width of the ADC is reduced.

In an implementation, the ADC may further adjust the real-time processing bit width of the ADC to n based on a second bit width indication signal, where n is a positive integer less than or equal to N. The following is described with reference to FIG. 23.

The low-power control module is further configured to: based on the received second bit width indication signal, send a third control signal to the first-stage sub-ADC, send a second selection signal to the first multiplexer, and send a fourth control signal to the second-stage sub-ADC, where the third control signal indicates the first-stage sub-ADC to skip performing analog-to-digital conversion on the first input analog signal; the second selection signal indicates the first multiplexer to select a signal that is input through the second input end; the fourth control signal indicates the second-stage sub-ADC to perform n-bit analog-to-digital conversion, where n is a positive integer less than or equal to N; and the second bit width indication signal is for representing that the processing bit width of the ADC is n.

The first-stage sub-ADC is further configured to: skip performing analog-to-digital conversion on the first input analog signal based on the received third control signal.

The first multiplexer is further configured to: select, based on the second selection signal, the first input analog signal (namely, Vin 1 in FIG. 23) that is input through the second input end as a third input analog signal (namely, Vin 3 in FIG. 23).

The first interstage amplifier (an RA 1 in FIG. 23) is further configured to: amplify the received third input analog signal (Vin 3), and send the third input analog signal (Vin 3) to the second-stage sub-ADC.

The second-stage sub-ADC is further configured to: perform analog-to-digital conversion on the third input analog signal (Vin 3) based on the second reference analog signal (Vref 2 in FIG. 23), to generate an n-bit digital signal (namely, D2_2 in FIG. 23), and send the n-bit digital signal (D2_2) to the digital control module.

The digital control module is further configured to: perform correction control on the received first n-bit digital signal (D2_2), to generate an n-bit output digital signal (namely, Dout 2 in FIG. 23).

According to this implementation, based on the received second bit width indication signal, the low-power control module in the ADC may control the first-stage sub-ADC not to operate, and control the real-time processing bit width of the second-stage sub-ADC to be adjusted to n. According to this method, the ADC may adjust the real-time processing bit width of the ADC to n based on the second bit width indication signal. Therefore, a preceding-stage module may send the second bit width indication signal to the ADC based on an amplitude of service data or another case, to adjust the processing bit width of the ADC. In this way, power consumption of the ADC is reduced after the processing bit width of the ADC is reduced.

In this embodiment of this application, the first bit width indication signal is a first bit sequence of H bits, and the second bit width indication signal is a second bit sequence of H bits, where 2^{H} is greater than or equal to M+N; and a decimal value of the first bit sequence is equal to m+N, and a decimal value of the second bit sequence is equal to n.

For example, if M+N=16, the first bit width indication signal and the second indication signal may be 4-bit bit sequences.

Similar to the first indication signal or the second indication signal in Embodiment 1, in this embodiment, the first bit width indication signal or the second bit width indication signal is generated by the preceding-stage module of the ADC based on service data of a specified granularity, and the service data of the specified granularity is a single piece of sampled data, or service data received within specified time. The specified time may include at least one time unit. It should be noted that, a specific form of the time unit is not limited in this application. The time unit may be a time unit in the field of communication, such as a symbol, a slot, a subframe, or a radio frame, or may be a conventional time unit, such as a second, a minute, an hour, or a day. For example, a specific setting form of the specified granularity may be any one of time units shown in FIG. 24.

According to this implementation, the ADC may flexibly adjust the processing bit width based on the service data of the specified granularity. If the specified granularity is smaller, a potential power consumption gain of the ADC is greater.

Similar to Embodiment 1, a value of the first reference analog signal is the same as a value of the second reference analog signal; or a value of the second reference analog signal is equal to a value of the first reference analog signal×1/2^{K}, where K is a positive integer less than or equal to M; and an operation parameter of the first interstage amplifier is set based on the value of the first reference analog signal and the value of the second reference analog signal. For descriptions of the first reference analog signal and the second reference analog signal, refer to descriptions in Embodiment 1. Details are not described herein again.

It should be noted that, the foregoing embodiment and instances are described by using an example in which there are two-stage sub-ADCs or three-stage sub-ADCs. However, the foregoing embodiment and instances do not constitute any limitation on an application scope of the solution provided in this embodiment of this application. The solution is applicable to various ADCs having multi-stage sub-ADCs.

### Embodiment 3

To reduce power consumption of an active component in an electronic device, an embodiment of this application provides an active module. The active module may be a component or an apparatus that consumes electric energy, such as a power amplifier (power amplifier, PA), a chip, an ADC, a DAC, or an ASIC. As shown in FIG. 25, the active module has the following three operation modes, and supports stable switching between the three modes.

Mode 1 is a no-load mode (ultimate power consumption, where power supply is shut down). The active component does not operate, and may transparently transmit a signal that is input to the active component.

Mode 2 is a low-load mode (low power consumption, where shutdown of power supply or a clock depends on a load change).

Mode 3 is a standard load mode (typical power consumption, where power supply and a clock are not shut down).

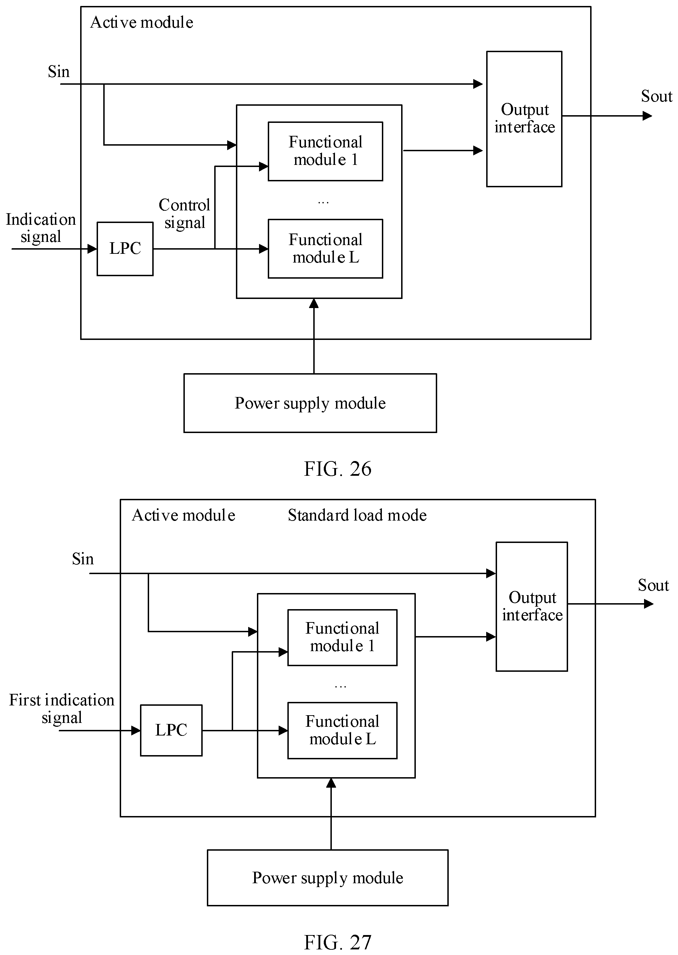

In an implementation, for a structure of the active module, refer to FIG. 26. There are a plurality of functional modules in the active module (for example, a functional module 1 to a functional module L in FIG. 26). The plurality of functional modules operate together, to complete standard operation of the active module.

After an input signal (for example, Sin in FIG. 26) is input to the active module, each of the functional modules in the active module may process the input signal, and ultimately output a finally obtained output signal (namely, Sout in FIG. 26) through an output interface.

Optionally, the active module further includes an LPC. After receiving an indication signal, the LPC may control an operation state of each of the functional modules in the active module based on the indication signal (for example, control whether any one of the functional modules completes conventional operation, and/or control an operation gear of any one of the functional modules). In this way, the operation mode of the active module can be controlled.

In an implementation, the LPC controls, based on a received first indication signal, all functional modules in the active module to operate normally. In this case, the operation mode of the active module is the standard load mode. Refer to FIG. 27.

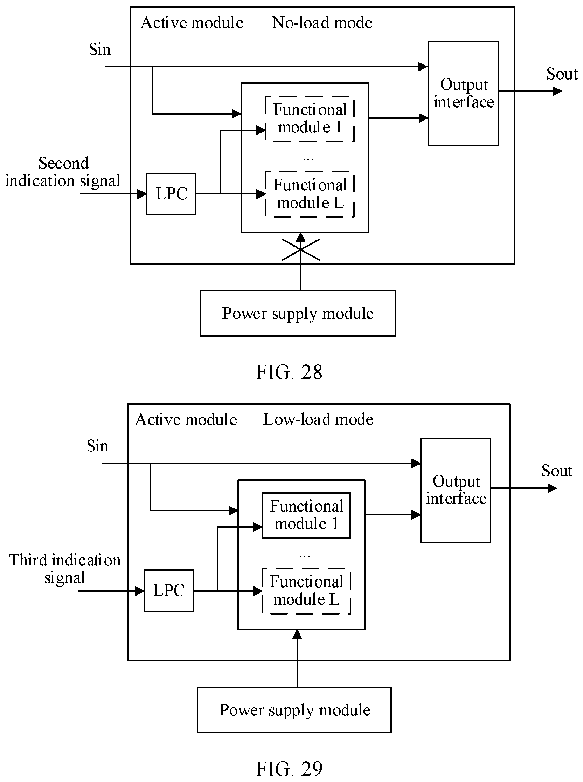

In another implementation, the LPC controls, based on a received second indication signal, all functional modules in the active module to stop operating, and a power supply module may stop supplying power to each of the functional modules. In this case, the operation mode of the active module is the no-load mode. Refer to FIG. 28. In this operation mode, the active module may transparently transmit a received signal, that is, Sout=Sin. Alternatively, the active module does not output a signal. A specific manner may be specifically designed based on a system requirement and an actual scenario. This is not limited in this application.

In still another implementation, the LPC may control, based on a received third instruction signal, a first functional module in the active module to operate normally and a second functional module to stop operating, and a power supply module directly powers off the second functional module. In this case, the operation mode of the active module is the low-load mode. Refer to FIG. 29. It should be noted that, there may be one or more first functional modules. This is not limited in this embodiment of this application.

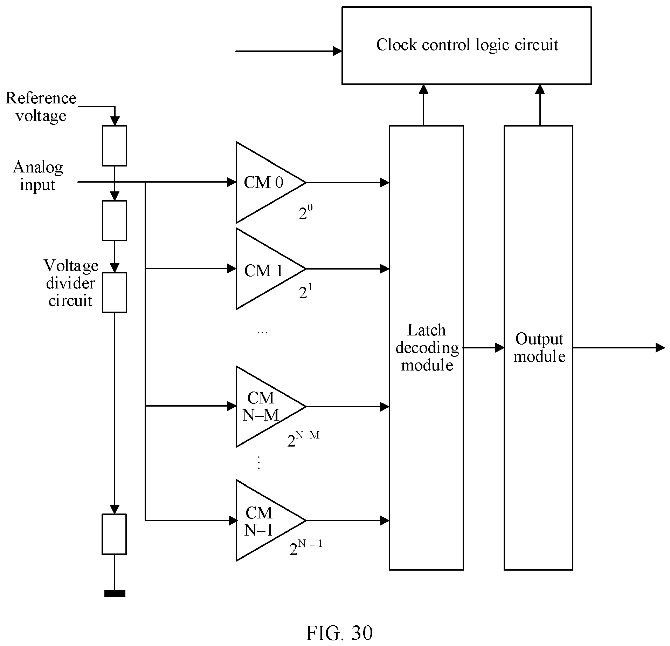

Based on the solution provided in Embodiment 3, this application further provides the following instances:
Instance 1: A structure of a conventional flash ADC is shown in FIG. 30, and mainly includes: a voltage divider circuit, a plurality of comparators (for example, CM 0 to CM N-1 shown in FIG. 30), a latch decoding module, an output module, a clock control logic circuit, and the like. For functions and operation principles that are of modules, refer to a conventional design solution of the flash ADC. Details are not described herein. Based on the conventional architecture shown in FIG. 30, in this instance, power consumption of the ADC may be reduced by using the following two solutions.

Solution 1: Directly control shutdown of a part of comparators based on bit_info information of a preceding-stage module.

Solution 2: Shut down a part of comparators based on a low-power indication generated by a gear control circuit.

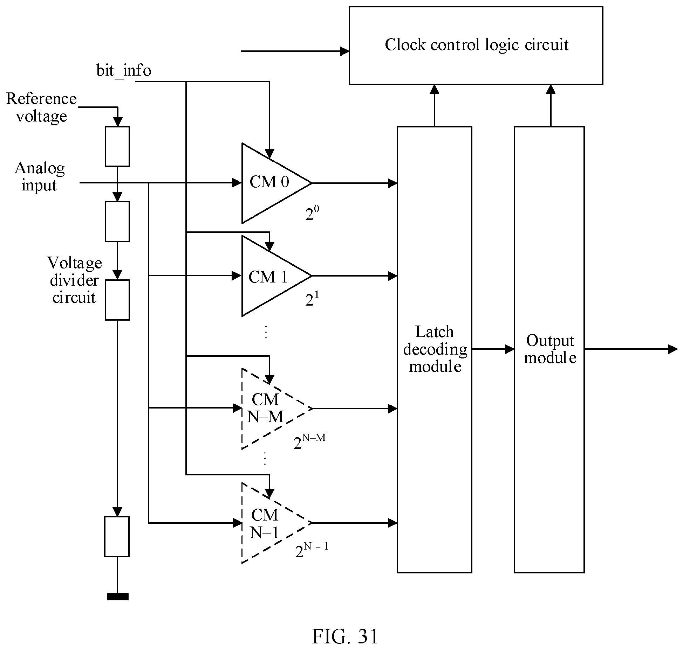

The following describes implementation of Solution 1 with reference to FIG. 31.

The preceding-stage module of the ADC may send an indication signal (for example, bit_info in FIG. 31) to the ADC, and bit_info may independently control enabling and shutdown of each comparator. For example, for an N-bit flash ADC, when input bit_info is a two-bit bit sequence, the ADC may shut down comparators other than a first comparator and a second comparator and related decoding links based on bit_info. In this way, power consumption of the flash ADC is reduced.

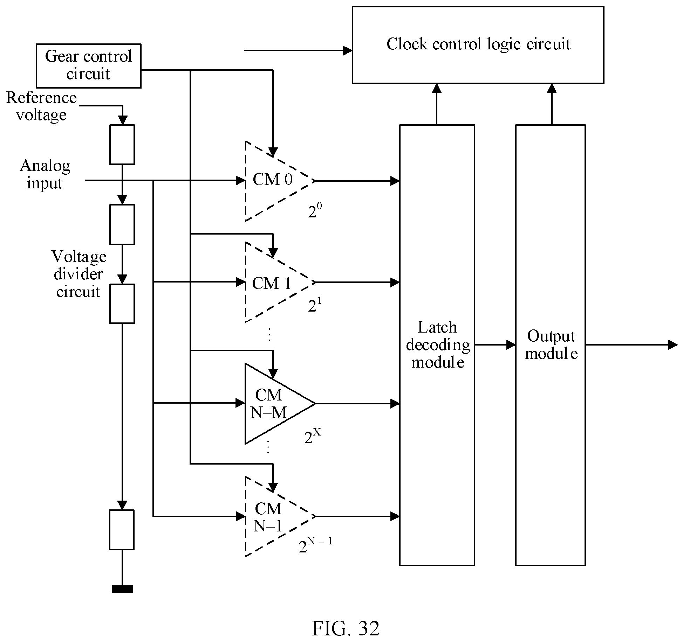

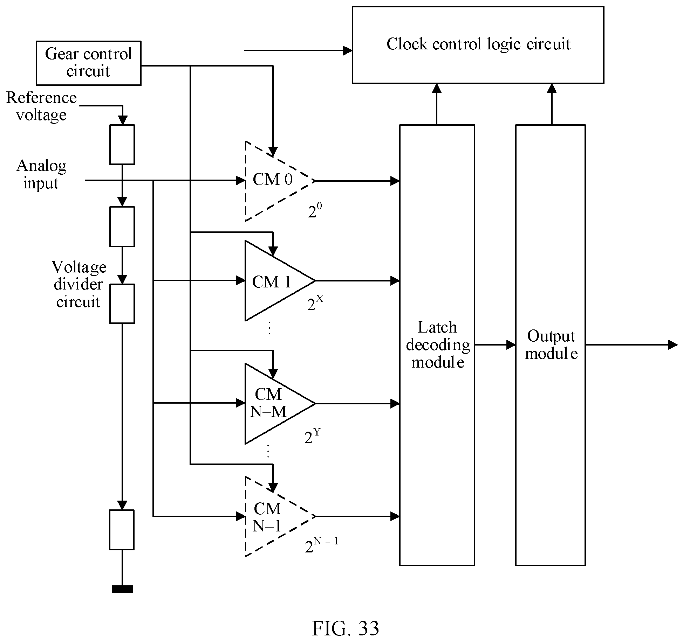

The following describes implementation of Solution 2 with reference to FIG. 32 and FIG. 33.

In Solution 2, an operation state of the ADC may be divided by gears via the gear control circuit, and data prediction is performed based on the gear. If an input analog signal is greater than a signal corresponding to the gear, the ADC operates normally. If an input analog signal is less than the signal corresponding to the gear, a sub-module, such as a comparator, whose signal level exceeds the gear is shut down. In this way, overall operating power consumption of the ADC is reduced.

FIG. 32 is a diagram in which the operation state of the ADC is divided by two gears. As shown in FIG. 32, a control signal output by the gear control circuit enables only a comparator corresponding to a bit X. This is equivalent to dividing the operation state of the ADC by two gears, where bits 0 to X-1 are of one gear, and bits above X are of the other gear. If an output of the comparator corresponding to the bit X is 0, only comparators corresponding to the bits 0 to X-1 are enabled, and other comparators corresponding to the bits above X are shut down. If an output of the comparator corresponding to the bit X is 1, all comparators operate normally in a conventional mode.

FIG. 32 shows only a case in which the ADC is divided by two gears. Based on the foregoing principle, this instance may be further extended to more gears such as three gears, and may be designed based on the gear control circuit. FIG. 33 is a diagram in which an operation state of the ADC is divided by three gears, and other more gears are not described.

Refer to FIG. 33. When the ADC is divided by three gears, the gear control circuit first enables comparators corresponding to two bits: a comparator corresponding to a bit X, and a comparator corresponding to a bit Y.

When the ADC operates, data judgment first starts to be performed from the comparator corresponding to the bit X. If an output of the comparator corresponding to the bit X is 0, only comparators corresponding to bits 0 to X-1 are enabled, and other comparators corresponding to bits above X are shut down. If an output of the comparator corresponding to the bit X is 1, the comparator corresponding to the bit Y continues to perform data judgment.

If an output of the comparator corresponding to the bit Y is 0, only comparators corresponding to bits 0 to Y-1 are enabled, and other comparators corresponding to bits above Y are shut down. If an output of the comparator corresponding to the bit Y is 1, all comparators in the ADC operate normally in a conventional mode.

### Instance 2:

Similar to Instance 1, a SAR ADC also successively performs comparison on each bit. Therefore, the ADC may also implement energy saving for a part of sub-modules such as a comparator via a bit_info signal of a preceding-stage module or a gear control circuit. For details, refer to descriptions in Instance 1. Details are not described herein again.

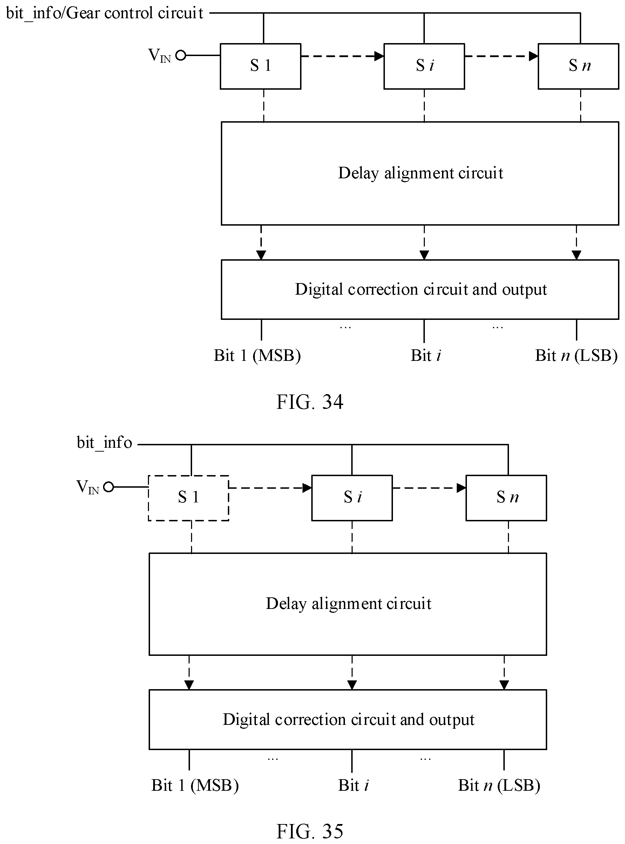

Instance 3: A pipeline-ADC includes multi-stage sub-ADCs. A differential structure is used and 1-bit analog-to-digital conversion is performed in each stage, and then a differential signal is transmitted to a next stage. For a structure of the pipeline-ADC, refer to FIG. 34. The ADC includes the multi-stage sub-ADCs (namely, a plurality of stages, for example, S 1 to S *n in* FIG. 34). For functions and operation principles of modules, refer to a conventional design solution of the pipeline-ADC. Details are not described herein.

Similar to Instance 1, in this instance, power consumption of the ADC may also be reduced by using two solutions.

Solution 1: The ADC may directly control, via bit_info of a preceding-stage module, shutdown of sub-ADCs of one stage or some stages in the multi-stage sub-ADCs. Refer to FIG. 35. For specific implementation of Solution 1, refer to descriptions of Solution 1 in Instance 1. Details are not described herein again.

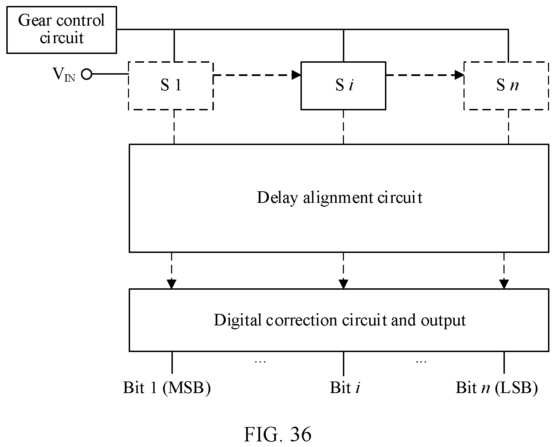

Solution 2: Shut down a part of sub-ADCs based on a low-power indication generated by a gear control circuit. Refer to FIG. 36. For specific implementation of Solution 2, refer to descriptions of Solution 2 in Instance 1. Details are not described herein again.

According to the foregoing embodiments and instances, this application further provides a chip. The chip includes at least one of the ADC or active module provided in the foregoing embodiments or instances.

According to the foregoing embodiments and instances, this application further provides a board or an active apparatus. The board or the active apparatus includes at least one of the ADC or active module provided in the foregoing embodiments or instances.

According to the foregoing embodiments and instances, this application further provides a signal processing apparatus. The apparatus includes at least one of the ADC or active module provided in the foregoing embodiments or instances.

According to the foregoing embodiments and instances, this application further provides a signal processing system. The system includes a processing unit and at least one of the ADC or active module provided in the foregoing embodiments or instances. The processing unit is configured to control, manage, and modulate a processing bit width of the ADC, or an operation mode of the active module. For example, the processing unit is configured to generate a first indication signal or a second indication signal; or generate a first bit width indication signal or a second bit width indication signal; or generate bit_info; or generate a low-power indication, or the like.

According to the foregoing embodiments and instances, this application further provides an electronic device (for example, a communication device such as a base station). The electronic device includes at least one of the ADC or active module provided in the foregoing embodiments or instances.

A person skilled in the art should understand that, embodiments of this application may be provided as a method, a system, or a computer program product. Therefore, in this application, a form of hardware only embodiments, software only embodiments, or embodiments with a combination of software and hardware may be used. In addition, in this application, a form of a computer program product that is implemented on one or more computer-usable storage media (including but not limited to a disk memory, a CD-ROM, an optical memory, and the like) including computer-usable program code may be used.

This application is described with reference to flowcharts and/or block diagrams of the method, the device (system), and the computer program product according to this application. It should be understood that, computer program instructions may be used to implement each procedure and/or each block in the flowcharts and/or the block diagrams and a combination of a procedure and/or a block in the flowcharts and/or the block diagrams. The computer program instructions may be provided for a general-purpose computer, a dedicated computer, an embedded processor, or a processor of another programmable data processing device to generate a machine, so that instructions executed by the computer or the processor of the another programmable data processing device generate an apparatus configured to implement a function specified in one or more procedures in the flowcharts and/or in one or more blocks in the block diagrams.

The computer program instructions may alternatively be stored in a computer-readable memory that can direct a computer or another programmable data processing device to operate in a specific manner, so that the instructions stored in the computer-readable memory generate an artifact including an instruction apparatus. The instruction apparatus implements a function specified in one or more procedures in the flowcharts and/or in one or more blocks in the block diagrams.

The computer program instructions may alternatively be loaded onto a computer or another programmable data processing device, so that a series of operation steps are performed on the computer or the another programmable device to generate computer-implemented processing, so that instructions executed on the computer or the another programmable device provide steps for implementing a function specified in one or more procedures in the flowcharts and/or in one or more blocks in the block diagrams.

It is clear that, a person skilled in the art may make various modifications and variations to this application without departing from the protection scope of this application. In this way, provided that the modifications and the variations to this application fall within the scope of the claims of this application and equivalent technologies of the claims, this application is also intended to include the modifications and variations.

## Claims

1. An analog-to-digital converter ADC, comprising: a first-stage sub-ADC, a second-stage sub-ADC, a first interstage amplifier, a digital control module, a low-power control module, and a first multiplexer, wherein
the low-power control module is configured to: send a first control signal to the first-stage sub-ADC and send a first selection signal to the first multiplexer based on a received first indication signal; or send a second control signal to the first-stage sub-ADC and send a second selection signal to the first multiplexer based on a received second indication signal, wherein the first control signal indicates the first-stage sub-ADC to perform analog-to-digital conversion on a first input analog signal; the first selection signal indicates the first multiplexer to select a signal that is input through a first input end; the second control signal indicates the first-stage sub-ADC to skip performing analog-to-digital conversion on a first input analog signal; and the second selection signal indicates the first multiplexer to select a signal that is input through a second input end;
the first-stage sub-ADC is configured to: when receiving the first control signal, perform analog-to-digital conversion on the first input analog signal based on the first control signal and a first reference analog signal, to generate a first M-bit digital signal, and send the first M-bit digital signal to the digital control module; correct the first input analog signal based on the first M-bit digital signal, to generate the first corrected input analog signal; and send the first corrected input analog signal to the first input end of the first multiplexer;
the first-stage sub-ADC is further configured to: when receiving the second control signal, skip performing analog-to-digital conversion on the first input analog signal based on the second control signal;
the first multiplexer is configured to: receive the first corrected input analog signal from the first-stage sub-ADC through the first input end, and receive the first input analog signal through the second input end; when receiving the first selection signal, select, based on the first selection signal, the signal that is input through the first input end as a second input analog signal; or when receiving the second selection signal, select, based on the second selection signal, the signal that is input through the second input end as a second input analog signal; and send the second input analog signal to the first interstage amplifier;
the first interstage amplifier is configured to: amplify the received second input analog signal, and send a signal obtained by amplifying the second input analog signal to the second-stage sub-ADC;
the second-stage sub-ADC is configured to: perform analog-to-digital conversion on the second input analog signal based on a second reference analog signal, to generate a first N-bit digital signal, and send the first N-bit digital signal to the digital control module; and
the digital control module is configured to: perform correction control on the received first M-bit digital signal and the received first N-bit digital signal, to generate a first (M+N)-bit output digital signal; or perform correction control on the received first N-bit digital signal, to generate a first N-bit output digital signal, wherein M is a positive integer, and N is a positive integer.

2. The ADC according to claim 1, wherein the low-power control module is specifically configured to:
in a first mode, send the first control signal to the first-stage sub-ADC and send the first selection signal to the first multiplexer based on the received first indication signal; or, send the second control signal to the first-stage sub-ADC and send the second selection signal to the first multiplexer based on the received second indication signal;
the low-power control module is further configured to:
in a second mode, send a third control signal to the first-stage sub-ADC, wherein the third control signal indicates the first-stage sub-ADC to determine, based on a magnitude of the first input analog signal, whether to perform analog-to-digital conversion on the first input analog signal;
the first-stage sub-ADC is further configured to:
compare the first input analog signal with a specified signal based on the third control signal; and
when the first input analog signal is greater than the specified signal, perform analog-to-digital conversion on the first input analog signal based on the first reference analog signal, to generate a second M-bit digital signal, and send the second M-bit digital signal to the digital control module; correct the first input analog signal based on the second M-bit digital signal, to generate a second corrected input analog signal; send the second corrected input analog signal to the first input end of the first multiplexer; and send a third selection signal to the first multiplexer, wherein the third selection signal indicates the first multiplexer to select the signal that is input through the first input end; or
when the first input analog signal is less than the specified signal, skip performing analog-to-digital conversion on the first input analog signal; and send a fourth selection signal to the first multiplexer, wherein the fourth selection signal indicates the first multiplexer to select the signal that is input through the second input end;
the first multiplexer is further configured to: receive the second corrected input analog signal from the first-stage sub-ADC through the first input end, and receive the first input analog signal through the second input end; when receiving the third selection signal, select, based on the third selection signal, the signal that is input through the first input end as a third input analog signal; or when receiving the fourth selection signal, select, based on the fourth selection signal, the signal that is input through the second input end as a third input analog signal; and send the third input analog signal to the first interstage amplifier;
the first interstage amplifier is further configured to: amplify the received third input analog signal, and send a signal obtained by amplifying the third input analog signal to the second-stage sub-ADC;
the second-stage sub-ADC is further configured to: perform analog-to-digital conversion on the third input analog signal based on the second reference analog signal, to generate a second N-bit digital signal, and send the second N-bit digital signal to the digital control module; and
the digital control module is further configured to: perform correction control on the received second M-bit digital signal and the received second N-bit digital signal, to generate a second (M+N)-bit output digital signal; or perform correction control on the received second N-bit digital signal, to generate a second N-bit output digital signal.

3. The ADC according to claim 2, wherein a value of the specified signal is equal to a value of the first reference analog signal×1/2^{M}.

4. The ADC according to claim 2 or 3, wherein the low-power control module comprises a selection control module and a signal generation module;
the signal generation module is configured to: generate, in the second mode, the third control signal; and
the selection control module is configured to: receive the first indication signal or the second indication signal through a first input end; and receive the third control signal of the signal generation module through a second input end; and
in the first mode, send the first control signal to the first-stage sub-ADC and send the first selection signal to the first multiplexer based on the first indication signal received through the first input end; or send the second control signal to the first-stage sub-ADC and send the second selection signal to the first multiplexer based on the second indication signal received through the first input end; or
send, in the second mode, the third control signal received through the second input end to the first-stage sub-ADC.

5. The ADC according to claim 4, wherein the selection control module is a second multiplexer; and a value of the first indication signal, a value of the first control signal, and a value of the first selection signal are the same; or a value of the second indication signal, a value of the second control signal, and a value of the second selection signal are the same; and
the second multiplexer is configured to: select, in the first mode, a signal that is input through the first input end; or select, in the second mode, a signal that is input through the second input end.

6. The ADC according to any one of claims 1 to 5, wherein the first indication signal or the second indication signal is generated by a preceding-stage module of the ADC based on service data of a specified granularity, and the service data of the specified granularity is a single piece of sampled data, or service data received within specified time.

7. The ADC according to any one of claims 1 to 6, wherein the value of the first reference analog signal is the same as a value of the second reference analog signal; or a value of the second reference analog signal is equal to the value of the first reference analog signal×1/2^{K}, wherein K is a positive integer less than or equal to M; and
an operation parameter of the first interstage amplifier is set based on the value of the first reference analog signal and the value of the second reference analog signal.

8. The ADC according to claim 2, wherein a value of the second reference analog signal is equal to a value of the first reference analog signal×1/2^{M}, and the specified signal is the second reference analog signal; and
the first-stage sub-ADC comprises a controller, and the controller is configured to: when receiving the third control signal, turn on a switch between the second reference analog signal and the first-stage sub-ADC.

9. An analog-to-digital converter ADC, comprising: a first-stage sub-ADC, a second-stage sub-ADC, a first interstage amplifier, a digital control module, a low-power control module, and a first multiplexer, wherein
the low-power control module is configured to: based on a received first bit width indication signal, send a first control signal to the first-stage sub-ADC, send a first selection signal to the first multiplexer, and send a second control signal to the second-stage sub-ADC, wherein the first control signal indicates the first-stage sub-ADC to perform m-bit analog-to-digital conversion, and m is a positive integer less than or equal to a maximum processing bit width M of the first-stage sub-ADC; the first selection signal indicates the first multiplexer to select a signal that is input through a first input end; the second control signal indicates the second-stage sub-ADC to perform N-bit analog-to-digital conversion, and N is a maximum processing bit width of the second-stage sub-ADC; M is a positive integer, and N is a positive integer; and the first bit width indication signal is for representing that a processing bit width of the ADC is m+N;
the first-stage sub-ADC is configured to: perform analog-to-digital conversion on a first input analog signal based on the received first control signal and a first reference analog signal, to generate an m-bit digital signal, and send the m-bit digital signal to the digital control module; correct the first input analog signal based on the m-bit digital signal, to generate the first corrected input analog signal; and send the first corrected input analog signal to the first input end of the first multiplexer;
the first multiplexer is configured to: receive the first corrected input analog signal from the first-stage sub-ADC through the first input end, and receive the first input analog signal through a second input end; and when receiving the first selection signal, select, based on the first selection signal, the signal that is input through the first input end as a second input analog signal;
the first interstage amplifier is configured to: amplify the received second input analog signal, and send a signal obtained by amplifying the second input analog signal to the second-stage sub-ADC;
the second-stage sub-ADC is configured to: perform analog-to-digital conversion on the second input analog signal based on a second reference analog signal, to generate an N-bit digital signal, and send the N-bit digital signal to the digital control module; and
the digital control module is configured to: perform correction control on the received m-bit digital signal and the received first N-bit digital signal, to generate an (m+N)-bit output digital signal.

10. The ADC according to claim 9, wherein
the low-power control module is further configured to: based on a received second bit width indication signal, send a third control signal to the first-stage sub-ADC, send a second selection signal to the first multiplexer, and send a fourth control signal to the second-stage sub-ADC, wherein the third control signal indicates the first-stage sub-ADC to skip performing analog-to-digital conversion on the first input analog signal; the second selection signal indicates the first multiplexer to select a signal that is input through the second input end; the fourth control signal indicates the second-stage sub-ADC to perform n-bit analog-to-digital conversion, wherein n is a positive integer less than or equal to N; and the second bit width indication signal is for representing that a processing bit width of the ADC is n;
the first-stage sub-ADC is further configured to: skip performing analog-to-digital conversion on the first input analog signal based on the received third control signal;
the first multiplexer is further configured to: select, based on the second selection signal, the first input analog signal that is input through the second input end as a third input analog signal;
the first interstage amplifier is further configured to: amplify the received third input analog signal, and send a signal obtained by amplifying the third input analog signal to the second-stage sub-ADC;
the second-stage sub-ADC is further configured to: perform analog-to-digital conversion on the third input analog signal based on the second reference analog signal, to generate an n-bit digital signal, and send the n-bit digital signal to the digital control module; and
the digital control module is further configured to: perform correction control on the received first n-bit digital signal, to generate an n-bit output digital signal.

11. The ADC according to claim 10, wherein the first bit width indication signal is a first bit sequence of H bits, and the second bit width indication signal is a second bit sequence of H bits, wherein 2^{H} is greater than or equal to M+N; and
a decimal value of the first bit sequence is equal to m+N, and a decimal value of the second bit sequence is equal to n.

12. The ADC according to claim 10 or 11, wherein the first bit width indication signal or the second bit width indication signal is generated by a preceding-stage module of the ADC based on service data of a specified granularity, and the service data of the specified granularity is a single piece of sampled data, or service data received within specified time.

13. The ADC according to any one of claims 9 to 12, wherein a value of the first reference analog signal is the same as a value of the second reference analog signal; or a value of the second reference analog signal is equal to a value of the first reference analog signal×1/2^{K}, wherein K is a positive integer less than or equal to M; and
an operation parameter of the first interstage amplifier is set based on the value of the first reference analog signal and the value of the second reference analog signal.

14. A chip, comprising:
the ADC according to any one of claims 1 to 13.

15. A signal processing apparatus, comprising:
the ADC according to any one of claims 1 to 13.

16. A signal processing system, comprising a processing unit and the ADC according to any one of claims 1 to 13, wherein
the processing unit is configured to generate a first indication signal or a second indication signal.

17. A signal processing system, comprising a processing unit and the ADC according to any one of claims 1 to 13, wherein
the processing unit is configured to generate a first bit width indication signal or a second bit width indication signal.
